(19) Europäisches Patentamt / European Patent Office / Office européen des brevets

(11) **EP 1 865 542 A1**

(12) **EUROPEAN PATENT APPLICATION**
published in accordance with Art. 158(3) EPC

(43) Date of publication:
**12.12.2007 Bulletin 2007/50**

(51) Int Cl.:
*H01L 21/027* (2006.01)    *G03F 7/20* (2006.01)

(21) Application number: **06730659.7**

(22) Date of filing: **30.03.2006**

(86) International application number:
**PCT/JP2006/306711**

(87) International publication number:
**WO 2006/106851 (12.10.2006 Gazette 2006/41)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **31.03.2005 JP 2005101485**
**09.06.2005 JP 2005169544**

(71) Applicant: **NIKON CORPORATION**
**Tokyo 100-8331 (JP)**

(72) Inventor: **NAGASAKA, Hiroyuki,**
**c/o NIKON CORPORATION**
**Tokyo 1008331 (JP)**

(74) Representative: **Viering, Jentschura & Partner**
**Grillparzerstrasse 14**
**81675 München (DE)**

(54) **EXPOSURE APPARATUS, EXPOSURE METHOD, AND DEVICE PRODUCTION METHOD**

(57)    An exposure apparatus includes a first land surface 75 which faces a surface of a substrate and which surrounds an optical path space K1 for an exposure light beam, a second land surfaces 76 which faces the surface of the substrate and which is provided outside the first land surface 75 in a predetermined direction, and a recovery port 22 which is provided to recover a liquid for filling the optical path space K1 therewith. The first land surface 75 is provided subsequently in parallel to the surface of the substrate. The second land surface 76 is provided at positions separated farther from the surface of the substrate than the first land surface 75. The recovery port 22 is provided outside the first land surface 75 and the second land surface 76. Even when the exposure is performed while moving the substrate, the optical path space for the exposure light beam can be filled with the liquid in a desired state.

Fig. 1

## Description

TECHNICAL FIELD

The present invention relates to an exposure apparatus, an exposure method, and a method for producing a device, in which a substrate is exposed through a liquid.

BACKGROUND ART

An exposure apparatus, which projects a pattern formed on a mask onto a photosensitive substrate, is used in the photolithography step as one of the steps of producing microdevices such as semiconductor devices and liquid crystal display devices. The exposure apparatus includes a mask stage which is movable while holding the mask and a substrate stage which is movable while holding the substrate. The pattern of the mask is projected onto the substrate via a projection optical system while successively moving the mask stage and the substrate stage. In the microdevice production, it is required to realize a miniaturization of a pattern to be formed on the substrate in order to achieve a high density of the device. In order to respond to this requirement, it is demanded to realize a higher resolution of the exposure apparatus. A liquid immersion exposure apparatus, in which the optical path space for the exposure light beam between the projection optical system and the substrate is filled with a liquid to expose the substrate via the projection optical system and the liquid, has been contrived as one of means to realize the high resolution, as disclosed in pamphlet of International Publication No. 99/49504.

DISCLOSURE OF THE INVENTION

Problem to Be Solved by the Invention:

As for the exposure apparatus, it is demanded to realize a high movement velocity of the substrate (substrate stage) in order to improve, for example, the productivity of the device and the like. However, when the substrate (substrate stage) is moved at a high velocity, the following possibility arises. That is, it is difficult to fill the optical path space for the exposure light beam with the liquid in a desired state. Further, there is such a possibility that the exposure accuracy and the measurement accuracy, which are to be obtained through the liquid, may be deteriorated. For example, as the velocity of the movement of the substrate (substrate stage PST) is increased to be high, the following inconvenience arises. That is, it is impossible to sufficiently fill the optical path space for the exposure light beam with the liquid, and the bubble is formed in the liquid, etc. When the inconvenience arises as described above, then the exposure light beam does not arrive at the surface of the substrate satisfactorily. As a result, the pattern is not formed on the substrate, or any defect appears in the pattern formed on the substrate. Further, when the velocity of the movement of the substrate (substrate stage PST) is increased to be high, a possibility arises such that the liquid, with which the optical path space is filled, may leak out as well. When the liquid leaks out, for example, the corrosion and the trouble of peripheral members and equipment are caused. For example, when the leaked liquid and the unsuccessfully recovered liquid remain as liquid droplets on the substrate, there is also such a possibility that the adhesion trace of the liquid (so-called water mark) may be formed on the substrate due to the vaporization of the remaining liquid (liquid droplets). The heat of vaporization of the leaked liquid may cause the thermal deformation of, for example, the substrate and the substrate stage as well as the variation of the environment (for example, the humidity and the cleanness) in which the exposure apparatus is placed. As a result, it is feared that the exposure accuracy, which includes, for example, the pattern overlay accuracy on the substrate, may be deteriorated, and the various measurement accuracies, which are based on the use of, for example, the interferometer, may be deteriorated. When the substrate, on which the liquid has remain (adhere), is unloaded from the substrate stage, it is feared that the liquid is also adhered to the transport system for holding the wetted substrate, and the damage may be expanded. As the velocity of the movement of the substrate (substrate stage PST) is increased to be high, there is such a possibility that the area, which is covered with the liquid, may be enormously expanded. As a result, it is feared that the entire exposure apparatus may be enormously large-sized as well.

The present invention has been made taking the foregoing circumstances into consideration, an object of which is to provide an exposure apparatus, an exposure method, and a method for producing a device based on the use of the exposure apparatus, in which the optical path space for the exposure light beam can be filled with a liquid in a desired state.

Means for Solving the Problem:

In order to achieve the object as described above, the present invention adopts the following constructions corresponding to respective drawings as illustrated in embodiments. However, parenthesized reference numerals affixed to respective elements merely exemplify the elements by way of example, with which it is not intended to limit the respective elements.

According to a first aspect of the present invention, there is provided an exposure apparatus (EX) which exposes a substrate (P) by radiating an exposure light beam (EL) onto the substrate (P) while moving the substrate (P) in a predetermined direction; the exposure apparatus comprising a first surface (75) which is provided opposite to a surface of an object (P) arranged at a position capable of being irradiated with the exposure light beam (EL) and which is provided to surround an optical path space (K1) for the exposure light beam (EL); a second surface (76) which is provided opposite to the surface of the object (P) and which is provided outside the first surface (75) with respect to the optical path space (K1) for the exposure light beam (EL) in the predetermined direction; and a recovery port (22) which recovers a liquid (LQ) for filling the optical path space (K1) for the exposure light beam (EL) therewith; wherein the first surface (75) is provided substantially in parallel to the surface of the object (P); the second surface (76) is provided at a position separated farther from the surface of the object (P) than the first surface (75); and the recovery port (22) is provided at a position different from those of the first surface (75) and the second surface (76).

According to the first aspect of the present invention, even when the substrate is exposed while moving the substrate in the predetermined direction, the optical path space for the exposure light beam can be filled with the liquid in a desired state.

According to a second aspect of the present invention, there is provided an exposure apparatus (EX) which exposes a substrate (P) by radiating an exposure light beam (EL) onto the substrate (P) while moving the substrate (P) in a predetermined direction; the exposure apparatus comprising a first surface (75) which is provided opposite to a surface of an object (P) arranged at a position capable of being irradiated with the exposure light beam (EL) and which is provided to surround an optical path space (K1) for the exposure light beam (EL); a second surface (76) which is provided opposite to the surface of the object (P) and which is provided outside the first surface (75) with respect to the optical path space (K1) for the exposure light beam (EL) in the predetermined direction; and a recovery port (22) which recovers a liquid (LQ) for filling the optical path space (K1) for the exposure light beam (EL) therewith; wherein the first surface (75) is provided substantially in parallel to the surface of the object (P); the second surface (76) is provided at a position separated farther from the surface of the object (P) than the first surface (75); and the recovery port (22) is provided on the second surface (76), and a size of the recovery port (22) is smaller than a size of the exposure light beam (EL) as viewed in a cross section.

According to the second aspect of the present invention, even when the substrate is exposed while moving the substrate in the predetermined direction, the optical path space can be filled with the liquid in a desired state by suppressing the influence which would be otherwise caused due to the presence of the recovery port.

According to a third aspect of the present invention, there is provided an exposure apparatus (EX) which exposes a substrate (P) by radiating an exposure light beam (EL) onto the substrate (P) while moving the substrate (P) in a predetermined direction; the exposure apparatus comprising a first surface (75) which is provided opposite to a surface of an object (P) arranged at a position capable of being irradiated with the exposure light beam (EL) and which is provided to surround an optical path space (K1) for the exposure light beam (EL); a second surface (76) which is provided opposite to the surface of the object (P) and which is provided outside the first surface (75) with respect to the optical path space (K1) for the exposure light beam (EL) in the predetermined direction; and a recovery port (22) which recovers a liquid (LQ) for filling the optical path space (K1) for the exposure light beam (EL) therewith; wherein the first surface (75) is provided substantially in parallel to the surface of the object (P); the second surface (76) is provided at a position separated farther from the surface of the object (P) than the first surface (75); and the first surface (75) and the second surface (76) are provided in a predetermined positional relationship to prevent the liquid (LQ), which exists between the surface of the object (P) and the second surface (76), from being separated from the second surface (76).

According to the third aspect of the present invention, even when the substrate is exposed while moving the substrate in the predetermined direction, the optical path space for the exposure light beam can be filled with the liquid in a desired state.

According to a fourth aspect of the present invention, there is provided an exposure apparatus (EX) which exposes a substrate (P) by radiating an exposure light beam (EL) onto the substrate (P) while moving the substrate (P) in a predetermined direction; the exposure apparatus comprising a first surface (75) which is provided opposite to a surface of an object (P) arranged at a position capable of being irradiated with the exposure light beam (EL) and which is provided to surround an optical path space (K1) for the exposure light beam (EL); a second surface (76) which is provided opposite to the surface of the object (P) and which is provided outside the first surface (75) with respect to the optical path space (K1) for the exposure light beam (EL) in the predetermined direction; and a recovery port (22) which recovers a liquid (LQ) for filling the optical path space (K1) for the exposure light beam (EL) therewith; wherein the first surface (75) is provided substantially in parallel to the surface of the object (P); the second surface (76) is provided substantially in parallel to the surface of the object (P) at a position separated farther from the surface of the object (P) the first surface (75); and a difference in height provided between the first surface (75) and the second surface (76) is not more than 1 mm.

According to the fourth aspect of the present invention, even when the substrate is exposed while moving the substrate in the predetermined direction, the optical path space for the exposure light beam can be filled with the liquid in a desired state.

According to a fifth aspect of the present invention, there is provided an exposure apparatus (EX) which exposes a substrate (P) by radiating an exposure light beam (EL) onto the substrate (P) while moving the substrate (P) in a predetermined direction; the exposure apparatus comprising a first surface (75) which is provided opposite to a surface of an object (P) arranged at a position capable of being irradiated with the exposure light beam (EL) and which is provided to surround an optical path space (K1) for the exposure light beam (EL); a second surface (76) which is provided opposite to the surface of the object (P) and which is provided outside the first surface (75) with respect to the optical path space (K1) for the exposure light beam (EL) in the predetermined direction; and a recovery port (22) which recovers a liquid (LQ) for filling the optical path space (K1) for the exposure light beam (EL) therewith; wherein the first surface (75) is provided substantially in parallel to the surface of the object (P); the second surface (76) is provided at a position separated farther from the surface of the object (P) than the first surface (75), the second surface (76) being an inclined surface in which a distance with respect to the surface of the object (P) is increased at positions separated farther from the optical path space (K1) for the exposure light beam (EL) in the predetermined direction; and an angle, which is formed by the first surface (75) and the second surface (76), is not more than 10 degrees.

According to the fifth aspect of the present invention, even when the substrate is exposed while moving the substrate in the predetermined direction, the optical path space for the exposure light beam can be filled with the liquid in a desired state.

According to a sixth aspect of the present invention, there is provided an exposure apparatus (EX) which exposes a substrate (P) by radiating an exposure light beam (EL) onto the substrate (P) while moving the substrate (P) in a predetermined direction; the exposure apparatus comprising a substrate stage (PST) which is movable while holding the substrate (P); and a nozzle member (70) which has a lower surface (76) arranged to surround an optical path space (K1) for the exposure light beam (EL) and to face an upper surface (94) of the substrate stage (PST) and which is capable of retaining a liquid (LQ) between the lower surface (76) and the upper surface (94) of the substrate stage (PST); wherein a movable range of the substrate stage (PST) is controlled to move an end (94E) of the upper surface (94) of the substrate stage (PST) in the predetermined direction to a position closer to the optical path space (K1) for the exposure light beam (EL) than an end (76E) of the lower surface (76) of the nozzle member (70) in a state in which the liquid (LQ) is retained between the lower surface (76) of the nozzle member (70) and at least one of the upper surface (94) of the substrate stage (PST) and a surface of the substrate (P) held by the substrate stage (PST).

According to the sixth aspect of the present invention, even when the substrate is exposed while moving the substrate in the predetermined direction, the optical path space for the exposure light beam can be filled with the liquid in a desired state.

According to a seventh aspect of the present invention, there is provided an exposure apparatus (EX) which exposes a substrate (P) by radiating an exposure light beam (EL) onto the substrate (P) through a liquid (LQ) while moving the substrate (P) in a predetermined direction; the exposure apparatus comprising a liquid immersion mechanism (for example, 70) which forms a liquid immersion area (LR) of the liquid (LQ) on the substrate; and a recovery port (22) which is provided in the liquid immersion mechanism (for example, 70) to recover the liquid (LQ) on the substrate (P); wherein the recovery port (22) is provided outside an extending area (EA) which extends to a side of the predetermined direction (Y) with respect to an optical path space (K1) for the exposure light beam which passes through the liquid (LQ).

According to the seventh aspect of the present invention, the recovery port of the liquid immersion mechanism is absent in the extending area. Therefore, even when the substrate is exposed while moving the substrate in the predetermined direction, the substrate can be exposed in a state in which the optical path space is filled with the liquid, while suppressing the remaining of, for example, droplets of the liquid on the substrate.

According to an eighth aspect of the present invention, there is provided an exposure method for exposing a substrate (P); the exposure method comprising providing a liquid (LQ) on the substrate; exposing the substrate (P) by radiating an exposure light beam (EL) through the liquid (LQ) onto the substrate (P) while moving the substrate (P) in a predetermined direction; and recovering the liquid outside an extending area (EA) which extends in the predetermined direction (Y) with respect to an optical path space (K1) for the exposure light beam which passes through the liquid (LQ).

According to the eighth aspect of the present invention, the liquid (LQ) is recovered from the outside of the extending area. Therefore, even when the substrate is exposed while moving the substrate in the predetermined direction, the substrate can be exposed in a state in which the optical path space is filled with the liquid, while suppressing the remaining of, for example, droplets of the liquid on the substrate.

According to a ninth aspect of the present invention, there is provided a method for producing a device; comprising exposing (204) a substrate by using the exposure apparatus (EX) as defined in any one of the aspects described above; developing (204) the exposed substrate; and processing (205) the developed substrate.

According to the ninth aspect of the present invention, it is possible to produce the device by using the exposure apparatus which makes it possible to fill the optical path space for the exposure light beam with the liquid in a desired state.

According to a tenth aspect of the present invention, there is provided a method for producing a device; comprising exposing (204) a substrate by using the exposure method as defined in the foregoing aspect; developing (204) the exposed substrate; and processing (205) the developed substrate.

According to the tenth aspect of the present invention, it is possible to produce the device by using the exposure method which makes it possible to fill the optical path space for the exposure light beam with the liquid in a desired state.

Effect of the Invention:

According to the present invention, it is possible to fill the optical path space for the exposure light beam with the liquid in a desired state, and it is possible to satisfactorily perform the exposure process and the measurement process through the liquid.

BRIEF DESCRIPTION OF THE DRAWINGS

Fig. 1 shows a schematic arrangement illustrating an exposure apparatus according to a first embodiment.

Fig. 2 shows a schematic perspective view with partial cutout, illustrating the vicinity of a nozzle member 70 according to the first embodiment.

Figs. 3(a) and 3(b) show a perspective view and a plan view illustrating the nozzle member 70 according to the first embodiment as viewed from a position below respectively.

Fig. 4 shows a side sectional view taken in parallel to the XZ plane as shown in Fig. 2.

Fig. 5 shows a side sectional view taken in parallel to the YZ plane as shown in Fig. 2.

Figs. 6(a) and 6(b) schematically illustrate the behavior of the liquid in accordance with the movement of the substrate respectively.

Fig. 7 schematically illustrates the behavior of the liquid in accordance with the movement of the substrate.

Figs. 8(a) and 8(b) schematically illustrate the behavior of the liquid in accordance with the movement of the substrate according to the first embodiment respectively.

Fig. 9 shows a schematic perspective view with partial cutout, illustrating the vicinity of a nozzle member 70 according to a second embodiment.

Fig. 10 shows a perspective view illustrating the nozzle member 70 according to the second embodiment as viewed from a position below.

Fig. 11 shows a side sectional view taken in parallel to the XZ plane as shown in Fig. 9.

Fig. 12 shows a side sectional view taken in parallel to the YZ plane as shown in Fig. 9.

Figs. 13(a) and 13(b) schematically illustrate the behavior of the liquid in accordance with the movement of the substrate according to the second embodiment respectively.

Fig. 14 shows a schematic perspective view with partial cutout, illustrating the vicinity of a nozzle member 70 according to a third embodiment.

Fig. 15 shows a perspective view illustrating the nozzle member 70 according to the third embodiment as viewed from a position below.

Fig. 16 shows a side sectional view taken in parallel to the XZ plane as shown in Fig. 14.

Fig. 17 shows a side sectional view taken in parallel to the YZ plane as shown in Fig. 17.

Fig. 18 schematically illustrates a fourth embodiment.

Fig. 19 shows an exemplary nozzle member to be used in the fourth embodiment as viewed from a position below.

Fig. 20 illustrates the principle of the liquid recovery operation performed by a liquid immersion mechanism.

Fig. 21 conceptually shows a state of the liquid and the nozzle member having a recovery port provided in an extending area which extends on the side in the scanning direction of the optical path space.

Fig. 22 shows a flow chart illustrating exemplary steps of producing a microdevice.

Legends of Reference Numerals:

1: liquid immersion mechanism, 12: liquid supply port, 16: discharge port (gas discharge port), 22: recovery port, 70: nozzle member, 70D: bottom plate portion, 74: opening, 75: first land surface, 76: second land surface, 76E: end, 77: upper surface, 78: recess, 79: recess, 80: third land surface, 94: upper surface, 94E: end, D4: difference in height, EL: exposure light beam, EX: exposure apparatus, G2: internal space, K1: optical path space, K3: external space, LQ: liquid, LR: liquid immersion area, LS1: final optical element, P: substrate, EA1, 2: extending area.

BEST MODE FOR CARRYING OUT THE INVENTION

Embodiments of the present invention will be explained below with reference to the drawings. However, the present invention is not limited thereto.

First Embodiment

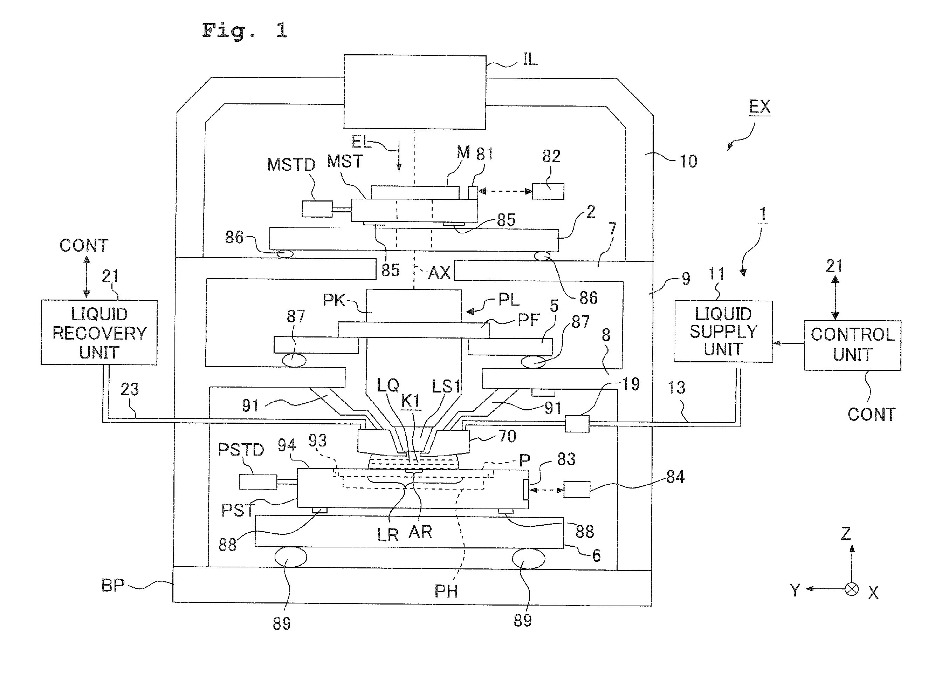

Fig. 1 shows a schematic arrangement illustrating an exposure apparatus according to a first embodiment. With reference to Fig. 1, the exposure apparatus EX includes a mask stage MST which is movable while holding a mask M, a substrate stage PST which is movable while holding a substrate P, an illumination optical system IL which illuminates, with an exposure light beam EL, the mask M held by the mask stage MST, a projection optical system PL which projects an image of a pattern of the mask M illuminated with the exposure light beam EL onto the substrate P held by the substrate stage PST, and a control unit CONT which controls the overall operation of the exposure apparatus EX.

The exposure apparatus EX of this embodiment is a liquid immersion exposure apparatus in which a liquid immersion method is applied in order that the exposure wavelength is substantially shortened to improve the resolution and the depth of focus is substantially widened. The exposure apparatus EX includes a liquid immersion mechanism 1 which is provided to fill, with a liquid LQ, an optical path space K1 for the exposure light beam EL, which is in the vicinity of the image plane of the projection optical system PL. The liquid immersion mechanism 1 includes a nozzle member 70 which is provided in the vicinity of the optical path space K1 and which has supply ports 12 for supplying the liquid LQ and recovery ports 22 for recovering the liquid LQ, a liquid supply unit 11 which supplies the liquid LQ via a supply tube 13 and the supply ports 12 provided for the nozzle member 70, and a liquid recovery unit 21 which recovers the liquid LQ via a recovery tube 23 and the recovery ports 22 provided for the nozzle member 70. As described in detail later on, a flow passage (supply flow passage) 14, which connects the supply port 12 and the supply tube 13, is provided in the nozzle member 70. Further, a flow passage (recovery flow passage) 24, which connects the recovery port 22 and the recovery tube 23, is provided in the nozzle member 70. The supply port, the recovery port, the supply flow passage, and the recovery flow passage are not shown in Fig. 1. The nozzle member 70 is formed to have an annular shape to surround a final optical element LS1 closest to the image plane of the projection optical system PL among a plurality of optical elements of the projection optical system PL.

The exposure apparatus EX of this embodiment adopts the local liquid immersion system in which a liquid immersion area LR of the liquid LQ is locally formed on a part of the substrate P including a projection area AR of the projection optical system PL, the liquid immersion area LR being larger than the projection area AR and smaller than the substrate P. The exposure apparatus EX projects the pattern image of the mask M onto the substrate P by radiating, onto the substrate P, the exposure light beam EL allowed to pass through the mask M via the projection optical system PL and the liquid LQ with which the optical path space K1 is filled, while the optical path space K1 for the exposure light beam EL, which is disposed between the final optical element LS1 closest to the image plane of the projection optical system PL and the substrate P arranged on the side of the image plane of the projection optical system PL, is filled with the liquid LQ at least during a period in which the pattern image of the mask M is projected onto the substrate P. The control unit CONT forms the liquid immersion area LR of the liquid LQ locally on the substrate P by filling the optical path space K1 with the liquid LQ while supplying a predetermined amount of the liquid LQ by using the liquid supply unit 11 of the liquid supply mechanism 1 and recovering a predetermined amount of the liquid LQ by using the liquid recovery unit 21.

The following explanation will be made about a case in which the optical path space K1 is filled with the liquid LQ in a state in which the substrate P is arranged at the position capable of being irradiated with the exposure light beam EL, i.e., in a state in which the substrate P faces the projection optical system PL. However, the present invention is also applicable equivalently when the optical path space K1 is filled with the liquid LQ in a state in which any object (for example, the upper surface of the substrate stage PST) other than the substrate P faces the projection optical system PL.

This embodiment will be explained as exemplified by a case of the use of the scanning type exposure apparatus (so-called scanning stepper) as the exposure apparatus EX in which the pattern formed on the mask M is transferred to the substrate P while synchronously moving the mask M and the substrate P in the scanning direction. In the following explanation, the Y axis direction is the synchronous movement direction (scanning direction) for the mask M and the substrate P in the horizontal plane, the X axis direction (non-scanning direction) is the direction which is perpendicular to the Y axis direction in the horizontal plane, and the Z axis direction is the direction which is perpendicular to the X axis direction and the Y axis direction and which is coincident with the optical axis AX of the projection optical system PL. The directions of rotation (inclination) about the X axis, the Y axis, and the Z axis are designated as θX, θY, and θZ directions respectively. The term "substrate" referred to herein includes those obtained by coating a base material such as a semiconductor wafer, for example, with a photosensitive material (photoresist), a protective film, and the like, and the term "mask" includes a reticle formed with a device pattern to be subjected to the reduction projection onto the substrate.

The exposure apparatus EX includes a base BP which is provided on the floor surface, and a main column 9 which is installed on the base BP. The main column 9 is provided with an upper stepped portion 7 and a lower stepped portion 8 which protrude to the inside of the main column 9. The illumination optical system IL is provided so that the mask M, which held by the mask stage MST, is illuminated with the exposure light beam EL. The illumination optical system IL is supported by a support frame 10 which is fixed to an upper portion of the main column 9.

The illumination optical system IL includes, for example, an optical integrator which uniformizes the illuminance of the light flux radiated from an exposure light source, a condenser lens which collects the exposure light beam EL emitted from the optical integrator, a relay lens system, a field diaphragm which sets the illumination area on the mask M illuminated with the exposure light beam EL, and the like. The predetermined illumination area on the mask M is illuminated with the exposure light beam EL having a uniform illuminance distribution by means of the illumination optical system IL. Those usable as the exposure light beam EL radiated from the illumination optical system IL include, for example, emission lines (g-ray, h-ray, i-ray) radiated, for example, from a mercury lamp, far ultraviolet light beams (DUV light beams) such as the KrF excimer laser beam (wavelength: 248 nm), and vacuum ultraviolet light beams (VUV light beams) such as the ArF excimer laser beam (wavelength: 193 nm) and the $F_2$ laser beam (wavelength: 157 nm). In this embodiment, the ArF excimer laser beam is used.

In this embodiment, pure or purified water is used as the liquid LQ. Not only the ArF excimer laser beam but also the emission line (g-ray, h-ray, i-ray) radiated, for example, from a mercury lamp and the far ultraviolet light beam (DUV light beam) such as the KrF excimer laser beam (wavelength: 248 nm) are also transmissive through pure or purified water.

The mask stage MST is movable while holding the mask M. The mask stage MST holds the mask M by means of the vacuum attraction (or the electrostatic attraction). A plurality of gas bearings (air bearings) 85, which are non-contact bearings, are provided on the lower surface of the mask stage MST. The mask stage MST is supported in a non-contact manner with respect to an upper surface (guide surface) of a mask stage-surface plate 2 by the air bearings 85. Openings, through which the pattern image of the mask M is allowed to pass, are formed at central portions of the mask stage MST and the mask stage-surface plate 2 respectively. The mask stage-surface plate 2 is supported by the upper stepped portion 7 of the main column 9 via an anti-vibration unit 86. That is, the mask stage MST is supported by the upper stepped portion 7 of the main column 9 via the anti-vibration unit 86 and the mask stage surface plate 2. The mask stage surface plate 2 is isolated from the main column 9 in terms of the vibration by the anti-vibration unit 86 so that the vibration of the main column 9 is not transmitted to the mask stage surface plate 2 which supports the mask stage MST.

The mask stage MST is two-dimensionally movable in the plane perpendicular to the optical axis AX of the projection optical system PL, i.e., in the XY plane, and it is finely rotatable in the θZ direction on the mask stage surface plate 2 in a state in which the mask M is held, by the driving operation of the mask stage-driving unit MSTD including, for example, a linear motor controlled by the control unit CONT. A movement mirror 81, which is movable together with the mask stage MST, is provided on the mask stage MST. A laser interferometer 82 is provided at a predetermined position with respect to the mask stage MST. The position in the two-dimensional direction and the angle of rotation in the θZ direction (including angles of rotation in the θX and θY directions in some cases) of the mask M on the mask stage MST are measured in real-time by the laser interferometer 82 by using the movement mirror 81. The result of the measurement of the laser interferometer 82 is outputted to the control unit CONT. The control unit CONT drives the mask stage-driving unit MSTD based on the result of the measurement obtained by the laser interferometer 82 to thereby control the position of the mask M held by the mask stage MST.

The projection optical system PL projects the pattern of the mask M onto the substrate P at a predetermined projection magnification β. The projection optical system PL includes a plurality of optical elements. The optical elements are held by a barrel PK. In this embodiment, the projection optical system PL is the reduction system in which the projection magnification β is, for example, 1/4, 1/5, or 1/8. The projection optical system PL may be any one of the 1x magnification system and the magnifying system. The projection optical system PL may be any one of the dioptric system including no catoptric optical element, the catoptric system including no dioptric optical element, and the cata-dioptric system including dioptric and catoptric optical elements. The final optical element LS1 closest to the image plane of the projection optical system PL in a plurality of optical elements of the projection optical system PL, is exposed from the barrel PK.

A flange PF is provided on the outer circumference of the barrel PK which holds the projection optical system PL. The projection optical system PL is supported by a barrel surface plate 5 via the flange PF. The barrel surface plate 5 is supported by the lower stepped portion 8 of the main column 9 via an anti-vibration unit 87. That is, the projection optical system PL is supported by the lower stepped portion 8 of the main column 9 via the anti-vibration unit 87 and the barrel surface plate 5. The barrel surface plate 5 is isolated from the main column 9 in terms of the vibration by the anti-vibration unit 87 so that the vibration of the main column 9 is not transmitted to the barrel surface plate 5 which supports the projection optical system PL.

The substrate stage PST has the substrate holder PH which holds the substrate P. The substrate stage PST is movable while holding the substrate P on the substrate holder PH. The substrate holder PH holds the substrate P, for example, by means of the vacuum attraction. A recess 93 is provided on the substrate stage PST. The substrate holder PH for holding the substrate P is arranged in the recess 93. The upper surface 94 other than the recess 93 of the substrate stage PST is a flat surface which has approximately the same height as that of (is flush with) the surface of the substrate P held by the substrate holder PH. Any difference in height may be provided between the upper surface 94 of the substrate stage PST and the surface of the substrate P held by the substrate holder PH provided that the optical path space K1 can be continuously filled with the liquid LQ.

A plurality of gas bearings (air bearings) 88, which are the non-contact bearings, are provided on the lower surface of the substrate stage PST. The substrate stage PST is supported in a non-contact manner by the air bearings 88 with respect to the upper surface (guide surface) of the substrate stage surface plate 6. The substrate stage surface plate 6 is supported on the base BP via an anti-vibration unit 89. The substrate stage surface plate 6 is isolated from the main column 9 and the base BP (floor surface) in terms of vibration by the anti-vibration unit 89 so that the vibration of the base BP (floor surface) and the main column 9 is not transmitted to the substrate stage surface plate 6 which supports the substrate stage PST.

The substrate stage PST is two-dimensionally movable in the XY plane, and it is finely rotatable in the θZ direction on the substrate stage surface plate 6 in a state in which the substrate P is held via the substrate holder PH, by the driving operation of the substrate stage-driving unit PSTD including, for example, the linear motor which is controlled by the control unit CONT. Further, the substrate stage PST is also movable in the Z axis direction, the θX direction, and the θY direction. Therefore, the surface of the substrate P held by the substrate stage PST is movable in the directions of six degrees of freedom of the X axis, Y axis, 2 axis, θX, θY, and θZ directions. A movement mirror 83, which is movable together with the substrate stage PST, is secured to the side surface of the substrate stage PST. A laser interferometer 84 is provided at a predetermined position with respect to the substrate stage PST. The angle of rotation and the position in the two-dimensional direction of the substrate P on the substrate stage PST are measured in real-time by the laser interferometer 84 by using the movement mirror 83. Although not shown in the drawing, the exposure apparatus EX has a focus/leveling-detecting system which detects the surface position information about the surface of the substrate P held by the substrate stage PST.

The result of the measurement by the laser interferometer 84 and the result of the detection by the focus/leveling-detecting system are outputted to the control unit CONT. The control unit CONT drives the substrate stage-driving unit PSTD on the basis of the detection result of the focus/leveling-detecting system to control the angle of inclination (θX, θY) and the focus position (Z position) of the substrate P so that the control unit CONT adjusts the positional relationship between the surface of the substrate P and the image plane formed via the projection optical system PL and the liquid LQ, and the control unit CONT controls the position of the substrate P in the X axis direction, the Y axis direction, and the θZ direction on the basis of the measurement result of the laser interferometer 84.

The liquid supply unit 11 of the liquid immersion mechanism 1 includes a tank for accommodating the liquid LQ, a pressurizing pump, a temperature-adjusting unit for adjusting the temperature of the liquid LQ to be supplied, a filter unit for removing any foreign matter contained in the liquid LQ, and the like. One end of the supply tube 13 is connected to the liquid supply unit 11. The other end of the supply tube 13 is connected to the nozzle member 70. The liquid supply operation of the liquid supply unit 11 is controlled by the control unit CONT. It is not necessarily that the exposure apparatus EX has all of the tank, the pressurizing pump, the temperature-adjusting mechanism, the filter unit, and the like of the liquid supply unit 11. It is also allowable to substitutively use any equipment of the factory or the like in which the exposure apparatus EX is installed.

A flow rate controller 19 called mass flow controller, which controls the amount of the liquid per unit time to be fed from the liquid supply unit 11 and supplied to the side of the image plane of the projection optical system PL, is provided at an intermediate position of the supply tube 13. The control of the liquid supply amount based on the use of the flow rate controller 19 is performed under the instruction signal of the control unit CONT.

The liquid recovery unit 21 of the liquid immersion mechanism 1 has a vacuum system such as a vacuum pump, a gas/liquid separator for separating the gas from the recovered liquid LQ, a tank for accommodating the recovered liquid LQ, and the like. One end of the recovery tube 23 is connected to the liquid recovery unit 21. The other end of the recovery tube 23 is connected to the nozzle member 70. The liquid recovery operation of the liquid recovery unit 21 is controlled by the control unit CONT. It is not necessarily that the exposure apparatus EX has all of the vacuum system, the gas/liquid separator, the tank, and the like of the liquid recovery unit 21. It is also allowable to substitutively use any equipment of the factory or the like in which the exposure apparatus EX is installed.

The nozzle member 70 is supported by a support mechanism 91. The support mechanism 91 is connected to the lower stepped portion 8 of the main column 9. The main column 9, which supports the nozzle member 70 via the support mechanism 91, is isolated in terms of vibration by the anti-vibration unit 87 from the barrel surface plate 5 which supports the barrel PK of the projection optical system PL via the flange PF. Therefore, the vibration, which is generated on the nozzle member 70, is prevented from being transmitted to the projection optical system PL. The main column 9 is isolated in terms of vibration by the anti-vibration unit 89 from the substrate stage surface plate 6 which supports the substrate stage PST. Therefore, the vibration, which is generated on the nozzle member 70, is prevented from being transmitted to the substrate stage PST via the main column 9 and the base BP. Further, the main column 9 is isolated in terms of vibration by the anti-vibration unit 86 from the mask stage surface plate 2 which supports the mask stage MST. Therefore, the vibration, which is generated on the nozzle member 70, is prevented from being transmitted to the mask stage MST via the main column 9.

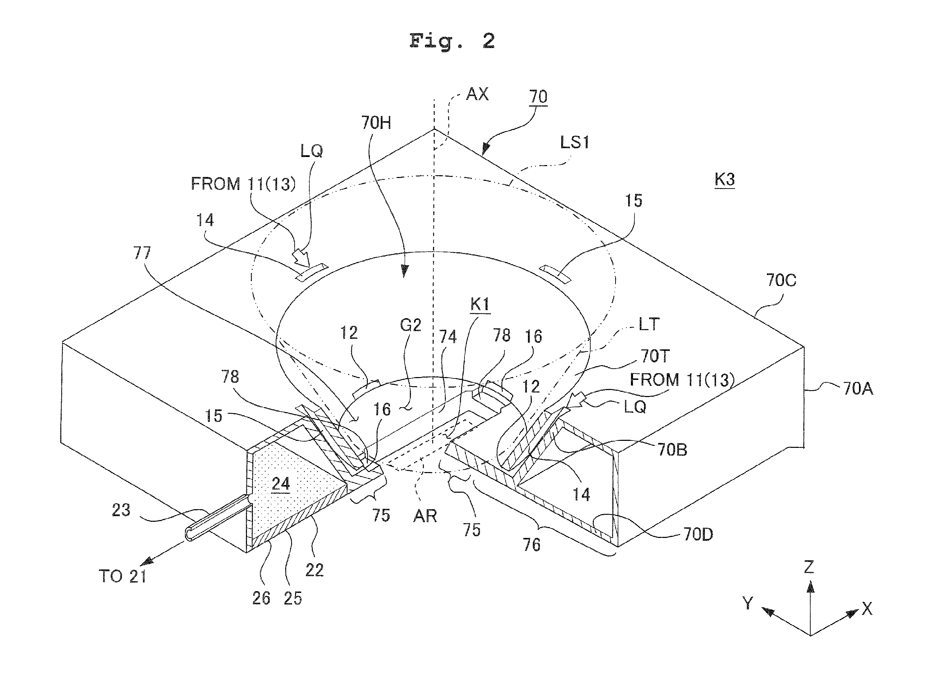

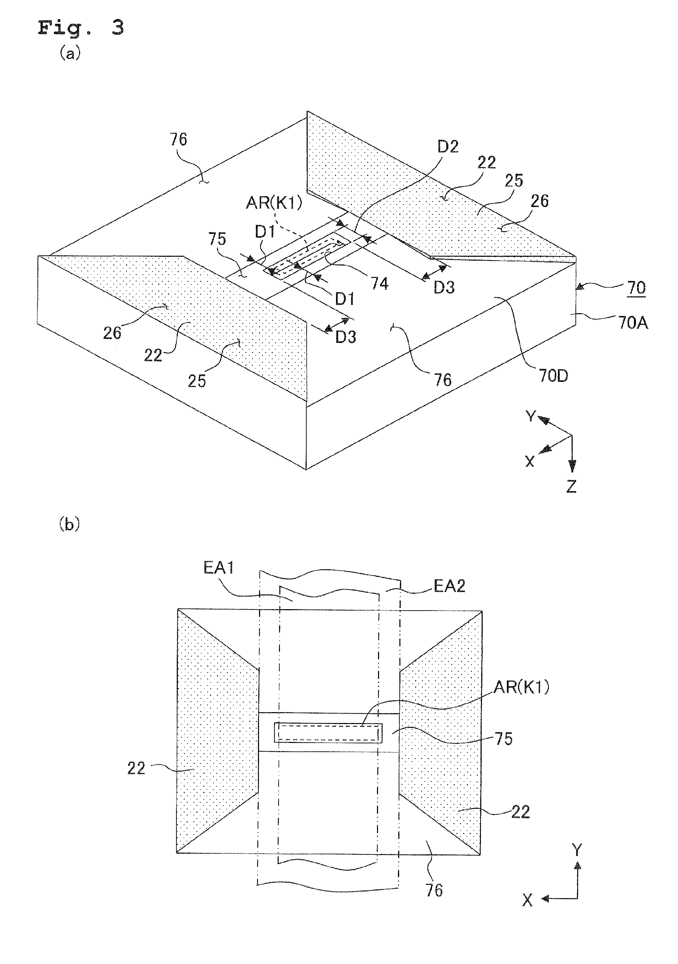

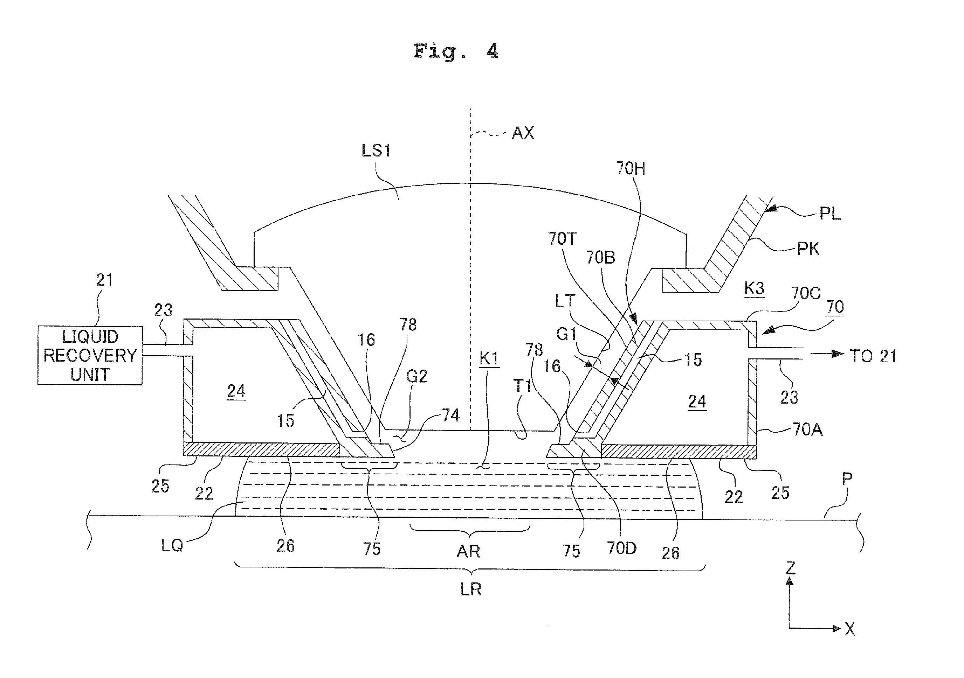

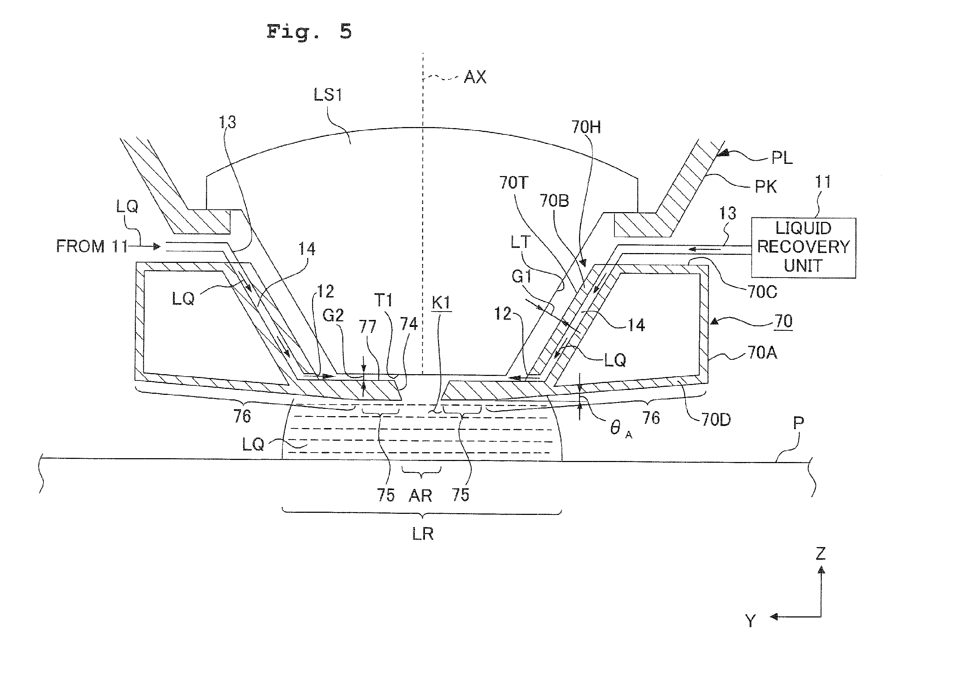

Next, an explanation will be made about the nozzle member 70 with reference to Figs. 2 to 5. Fig. 2 shows a schematic perspective view with partial cutout, illustrating the vicinity of the nozzle member 70. Fig. 3(a) shows a perspective view illustrating the nozzle member 70 as viewed from the lower side. Fig. 3(b) shows a plan view conceptually illustrating the nozzle member 70 as viewed from the lower side. Fig. 4 shows a side sectional view taken in parallel to the XZ plane. Fig. 5 shows a side sectional view taken in parallel to the YZ plane.

The nozzle member 70 is provided in the vicinity of the final optical element LS1 closest to the image plane of the projection optical system PL. The nozzle member 70 is the annular member which is provided to surround the final optical element LS1 over or above the substrate P (substrate stage PST). The nozzle member 70 has a hole 70H which is disposed at a central portion thereof and in which the projection optical system PL (final optical element LS1) can be arranged. In this embodiment, the nozzle member 70 is constructed by combining a plurality of members. The outer shape of the nozzle member 70 is substantially quadrangular as viewed in a plan view. The outer shape of the nozzle member 70 is not limited to the quadrangular shape as viewed in a plan view. For example, the nozzle member 70 may be circular as viewed in a plan view. The nozzle member 70 may be composed of one material (for example, titanium). Alternatively, for example, the nozzle member 70 may be composed of aluminum, titanium, stainless steel, duralumin, or any alloy containing them.

The nozzle member 70 has a side plate portion 70A, an inclined plate portion 70B, a ceiling plate portion 70C which is provided on the upper ends of the side plate portion 70A and the inclined plate portion 70B, and a bottom plate portion 70D which faces the substrate P (substrate stage PST). The inclined plate portion 70B is formed to have a mortar-shaped or cone-shaped form. The final optical element LS1 is arranged inside the hole 70H formed by the inclined plate portion 70B. The inner side surface 70T of the inclined plate portion 70B (i.e., the inner side surface for defining the hole 70H of the nozzle member 70) faces the side surface LT of the final optical element LS1 of the projection optical system PL. A predetermined gap G1 is provided between the inner side surface 70T of the inclined plate portion 70B and the side surface LT of the final optical element LS1. By providing the gap G1, the vibration, which is generated on the nozzle member 70, is prevented from being directly transmitted to the projection optical system PL (final optical element LS1). The inner side surface 70T of the inclined plate portion 70B is liquid-repellent or lyophobic (water-repellent) with respect to the liquid LQ. Therefore, it is suppressed that the liquid LQ inflows into the gap G1 between the side surface LT of the final optical element LS1 of the projection optical system PL and the inner side surface 70T of the inclined plate portion 70B. The liquid-repelling treatment, which is adopted to allow the inner side surface 70T of the inclined plate portion 70B to be liquid-repellent or lyophobic, includes, for example, treatments for applying or adhering any liquid-repellent or lyophobic material such as a fluorine-based resin material such as polytetrafluoroethylene (Teflon, trade name), an acrylic resin material, a silicon-based resin material, or the like.

A part of the bottom plate portion 70D is provided between the substrate P (substrate stage PST) and the lower surface T1 of the final optical element LS1 of the projection optical system PL in relation to the Z axis direction (see Fig. 1). An opening 74, through which the exposure light beam EL is allowed to pass, is formed at a central portion of the bottom plate portion 70D. The opening 74 is formed so that the exposure light beam EL, which is allowed to pass through the final optical element (optical member) LS1 of the projection optical system PL, passes therethrough. In this embodiment, the projection area AR, which is irradiated with the exposure light beam EL, is provided to be slit-shaped (substantially rectangular), in which the X axis direction (non-scanning direction) is the longitudinal direction. The opening 74 has the shape according to the projection area AR. In this embodiment, the opening 74 is formed to be slit-shaped (substantially rectangular), in which the X axis direction (non-scanning direction) is the longitudinal direction. The opening 74 is formed to be larger than the projection area AR. Therefore, the exposure light beam EL, which has passed through the projection optical system PL, can arrive at the surface of the substrate P without being shielded by the bottom plate portion 70D.

The lower surface of the nozzle member 70, which faces the substrate P (substrate stage PST), has a first area 75 which faces the surface of the substrate P arranged at the position capable of being irradiated with the exposure light beam EL. The first area 75 is a flat surface which is parallel to the XY plane. The first area 75 is provided to surround the optical path space K1 for the exposure light beam EL (The exposure light beam, which is allowed to pass through the space, forms the projection area AR on the substrate P. In this specification, it is intended that the "optical path space K1" is the space through which the exposure light beam passes. In this embodiment and in the following embodiments, the "optical path space K1" means the space through which the exposure light beam passes between the final optical element LS1 and the substrate P. The position and/or the size of the "optical path space K1" in the X direction or the Y direction can be represented, for example, by the position and/or the size of the area (area in the XY cross section of the exposure light beam EL) in which the exposure light beam EL intersects the XY plane including the first area (first land surface) 75). That is, the first area 75 is the surface provided to surround the opening 74 of the bottom plate portion 70D through which the exposure light beam EL is allowed to pass. The phrase "position capable of being irradiated with the exposure light beam EL" herein includes the position facing the projection optical system PL. The first area 75 is provided to surround the optical path space K1 for the exposure light beam EL allowed to pass through the projection optical system PL. Therefore, the control unit CONT is capable of allowing the first area 75 and the surface of the substrate P to face one another by controlling the substrate stage so that the substrate P is arranged at the position capable of being irradiated with the exposure light beam EL.

The surface of the substrate P held by the substrate stage PST is substantially parallel to the XY plane. Therefore, the first area 75 of the nozzle member 70 is provided so that the first area 75 faces the surface of the substrate P held by the substrate stage PST, and the first area 75 is substantially parallel to the surface (XY plane) of the substrate P. In the following description, the first area (flat surface) 75 of the nozzle member 70, which is provided to face the surface of the substrate P, which is provided to surround the optical path space K1 for the exposure light beam EL, and which is formed to be substantially parallel to the surface (XY plane) of the substrate P, is appropriately referred to as "first land surface 75".

The first land surface 75 is provided at the position on the nozzle member 70 so that the first land surface 75 is disposed most closely to the substrate P held by the substrate stage PST. That is, the first land surface 75 is the portion at which the gap becomes most reduced in size with respect to the surface of the substrate P held by the substrate stage PST. Accordingly, the liquid LQ can be satisfactorily retained between the first land surface 75 and the substrate P to form the liquid immersion area LR.

The first land surface 75 is provided to surround the optical path space K1 for the exposure light beam EL (projection area AR) in a space between the substrate P and the lower surface T1 of the projection optical system PL. As described above, the first land surface 75 is provided in a partial area of the lower surface of the nozzle member 70 (bottom plate portion 70D), and is provided to surround the opening 74 through which the exposure light beam EL is allowed to pass. The first land surface 75 has the shape according to the opening 74. In this embodiment, the outer shape of the first land surface 75 is formed to be rectangular, in which the X axis direction (non-scanning direction) is the longitudinal direction.

The opening 74 is provided at a substantially central portion of the first land surface 75. As shown in, for example, Fig. 3, the width D1 of the first land surface 75 in the Y axis direction (scanning direction) is smaller than the width D2 of the opening 74 in the Y axis direction. In this embodiment, the width D1 of the first land surface 75 in the Y axis direction is the distance between the +Y side end (-Y side end) of the first land surface 75 and the +Y side end (-Y side end) of the opening 74. In this embodiment, the opening 74 is provided at the substantially central portion of the first land surface 75. Therefore, the distance between the +Y side end of the first land surface 75 and the +Y side end of the opening 74 is approximately equal to the distance between the -Y side end of the first land surface 75 and the -Y side end of the opening 74.

In this embodiment, the width D1 of the first land surface 75 in the Y axis direction is smaller than the width D3 of the first land surface 75 in the X axis direction. In this embodiment, the width D3 of the first land surface 75 in the X axis direction is the distance between the +X side end (-X side end) of the first land surface 75 and the +X side end (-X side end) of the opening 74. In this embodiment, the opening 74 is provided at the substantially central portion of the first land surface 75. Therefore, the distance between the +X side end of the first land surface 75 and the +X side end of the opening 74 is approximately equal to the distance between the -X side end of the first land surface 75 and the -X side end of the opening 74.

The distance between the surface of the substrate P and the lower surface T1 of the final optical element LS1 is larger than the distance between the surface of the substrate P and the land surface 75. That is, the lower surface T1 of the final optical element LS1 is formed at the position higher than that of the first land surface 75. The bottom plate portion 70D is provided to make no contact with the lower surface T1 of the final optical element LS1 and the substrate P (substrate stage PST). As shown in, for example, Fig. 5, the space having a predetermined gap G2 is formed between the lower surface T1 of the final optical element LS1 and the upper surface 77 of the bottom plate portion 70D. The upper surface 77 of the bottom plate portion 70D is provided to surround the opening 74 through which the exposure light beam EL is allowed to pass. That is, the upper surface 77 of the bottom plate portion 70D is provided to surround the optical path space K1 for the exposure light beam EL, and faces the final optical element LS1 via the predetermined gap G2. In the following description, the space, which is disposed inside the nozzle member 70 and which includes the space between the lower surface T1 of the final optical element LS1 and the upper surface 77 of the bottom plate portion 70D, is appropriately referred to as "internal space G2".

The lower surface of the nozzle member 70 has a second area 76 which is provided at positions separated farther from the surface of the substrate P than the first land surface 75, which is provided outside the first land surface 75 with respect to the optical path space K1 for the exposure light beam EL in the Y axis direction, and which is provided opposite to the surface of the substrate P held by the substrate stage PST and arranged at the position capable of being irradiated with the exposure light beam EL. In the following description, the second area 76 of the nozzle member 70, which is provided at the positions separated farther from the surface of the substrate P than the first land surface 75 (at the positions different from that of the first land surface 75 in the height direction (Z direction)), which is provided outside the first land surface 75 with respect to the optical path space K1 for the exposure light beam EL in the Y axis direction, and which is provided opposite to the surface of the substrate P, are appropriately referred to as "second land surface 76".

In this embodiment, the second land surface 76 is an inclined surface in which the distance with respect to the substrate P is increased at positions separated farther from the optical path space K1 for the exposure light beam EL in the Y axis direction. The second land surface 76 is provided on one side (+Y side) and the other side (-Y side) in the scanning direction with respect to the first land surface 75 respectively. The surface of the substrate P held by the substrate stage PST is substantially parallel to the XY plane. Therefore, the second land surface 76 of the nozzle member 70 is provided so that the second surface 76 faces the surface of the substrate P held by the substrate stage PST and is inclined with respect to the surface (XY plane) of the substrate P.

The liquid LQ, which forms the liquid immersion area LR, makes contact with the first land surface 75 and part of the second land surfaces 76. The liquid LQ, with which the optical path space K1 is filled, also makes contact with the lower surface T1 of the final optical element LS1. That is, the first land surface 75 and the second land surfaces 76 of the nozzle member 70 and the lower surface T1 of the final optical element LS1 are the liquid contact surfaces to make contact with the liquid LQ respectively.

As described later on, when the liquid LQ is present in a space between the surface of the substrate P and the second land surfaces 76, the first land surface 75 and the second land surfaces 76 are provided in a predetermined positional relationship so that the liquid LQ, which exists in a space between the surface of the substrate P and the second land surfaces 76, is not separated from the second land surfaces 76. Specifically, the second land surfaces 76 are formed so that the liquid LQ, which exists in a space between the surface of the substrate P and the second land surfaces 76, is not separated (exfoliated) from the second land surfaces 76, even when the substrate P is moved in a state in which the optical path space K1 is filled with the liquid LQ.

In this embodiment, the second land surfaces 76 are provided continuously to the first land surface 75. That is, the -Y side edge of the second land surface 76 provided on the +Y side with respect to the optical path space K1, which is closest to the optical path space K1 for the exposure light beam EL, is provided at approximately the same position (height) as that of the +Y side edge of the first land surface 75 with respect to the substrate P. The +Y side edge of the second land surface 76 provided on the -Y side with respect to the optical path space K1, which is closest to the optical path space K1 for the exposure light beam EL, is provided at approximately the same position (height) as that of the -Y side edge of the first land surface 75 with respect to the substrate P. The angle $\theta_A$ formed by the first land surface 75 and the second land surface 76 is set to be not more than 10 degrees (see Fig. 5). In this embodiment, the angle $\theta_A$ formed by the first land surface 75 (XY plane) and the second land surface 76 is set to be about 4 degrees.

The first land surface 75 and the second land surface 76 have the liquid-attracting or lyophilic property with respect to the liquid LQ respectively. The contact angle between the first land surface 75 and the liquid LQ is approximately equal to the contact angle between the second land surface 76 and the liquid LQ. In this embodiment, the bottom plate portion 70D, which forms the first land surface 75 and the second land surfaces 76, is formed of titanium. A surface treatment (liquid-attracting or lyophilic treatment) may be performed to the first land surface 75 and the second land surfaces 76 in order to apply the liquid-attracting or lyophilic property with respect to the liquid LQ.

A passive film having the photocatalytic function is formed on the surface of the titanium material. It is possible to maintain the liquid-attracting or lyophilic property (water-attracting property) of the surface. Therefore, the contact angle of the liquid LQ on the first land surface 75 and the contact angle of the liquid LQ on the second land surface 76 can be maintained to be approximately identical to one another, for example, not more than 20°.

Each of the first land surface 75 and the second land surfaces 76 may be formed of stainless steel (for example, SUS 316) and may be performed with a surface treatment to suppress the elution of any impurity into the liquid LQ, or a surface treatment to enhance the liquid-attracting or lyophilic property. Such a surface treatment includes, for example, a treatment in which chromium oxide is deposited or adhered onto the first land surface 75 and the second land surfaces 76 respectively. For example, there are exemplified the "GOLDEP" treatment or the "GOLDEP WHITE" treatment available from Kobelco Eco-Solutions Co., Ltd.

The nozzle member 70 includes the supply ports 12 which supplies the liquid LQ for filling the optical path space K1 for the exposure light beam EL therewith, and the recovery ports 22 which recovers the liquid LQ for filling the optical path space K1 for the exposure light beam EL therewith. The nozzle member 70 further includes the supply flow passages 14 connected to the supply ports 12 and the recovery flow passages 24 connected to the recovery ports 22. Although not shown or simplified in Figs. 2 to 5, the supply flow passage 14 is connected to the other end of the supply tube 13, and the recovery flow passage 24 is connected to the other end of the recovery tube 23.

As shown in Figs. 2 and 5, the supply flow passage 14 is formed by a slit-shaped through-hole which penetrates through the inclined plate portion 70B of the nozzle member 70 parallel to the inclined direction. In this embodiment, the supply flow passage 14 is provided on the both sides in the Y axis direction with respect to the optical path space K1 (projection area AR) respectively. The upper end of the supply flow passage (through-hole) 14 is connected to the other end of the supply tube 13. Accordingly, the supply flow passage 14 is connected to the liquid supply unit 11 via the supply tube 13. On the other hand, the lower end of the supply flow passage 14 is provided in the vicinity of the internal space G2 between the lower surface T1 of the final optical element LS1 and the upper surface 77 of the bottom plate portion 70D. The lower end of the supply flow passage 14 is the supply port 12. That is, the supply port 12 is provided in the vicinity of the internal space G2 between the lower surface T1 of the final optical element LS1 and the upper surface 77 of the bottom plate portion 70D, and is connected to the internal space G2. In this embodiment, the supply ports 12 are provided at the respective predetermined positions disposed on the both sides in the Y axis direction, which intervene the optical path space K1 therebetween, outside the optical path space K1 for the exposure light beam EL.

The supply port 12 supplies the liquid LQ in order to fill the optical path space K1 therewith. The liquid LQ is supplied from the liquid supply unit 11 to the recovery port 12. The supply port 12 is capable of supplying the liquid LQ to the space between the lower surface T1 of the final optical element LS1 and the upper surface 77 of the bottom plate portion 70D, i.e., the internal space G2. The optical path space K1 for the exposure light beam EL, which is disposed between the final optical element LS1 and the substrate P, is filled with the liquid LQ by supplying the liquid LQ from the supply ports 12 to the internal space G2 between the final optical element LS1 and the bottom plate portion 70D.

As shown in Figs. 2 and 4, the nozzle member 70 includes the gas discharge ports or exhaust ports 16 which make communication between the internal space G2 and the external space K3. The gas discharge flow passages 15 are connected to the gas discharge ports 16. The gas discharge flow passage 15 is formed by a slit-shaped through-hole which penetrates through the inclined plate portion 70B of the nozzle member 70 parallel to the inclined direction. In this embodiment, the gas discharge ports 16 and the gas discharge flow passages 15 are provided on the both sides in the X axis direction with respect to the optical path space K1 (projection area AR) respectively. The upper end of the gas discharge flow passage (through-hole) 15 is connected to the external space (atmospheric space) K3, and is in a state of being open to the atmospheric air. On the other hand, the lower end of the gas discharge flow passage 15 is connected to the internal space G2 between the lower surface T1 of the final optical element LS1 and the upper surface 77 of the bottom plate portion 70D. The lower end of the gas discharge flow passage 15 is the gas discharge port 16. That is, the gas discharge port 16 is provided in the vicinity of the internal space G2 between the lower surface T1 of the final optical element LS1 and the upper surface 77 of the bottom plate portion 70D, and is connected to the internal space G2. In this embodiment, the gas discharge ports 16 are provided at the respective predetermined positions disposed on the both sides in the X axis direction, which intervene the optical path space K1 therebetween, outside the optical path space K1 for the exposure light beam EL. In this embodiment, a recess (stepped portion or difference in height) 78 is provided in the vicinity of the gas discharge port 16 disposed on the upper surface 77 of the bottom plate portion 70D. The gas discharge port 16 makes communication between the internal space G2 and the external space K3 via the gas discharge flow passage 15. Therefore, the gas contained in the internal space G2 can be discharged (evacuated) to the external space K3 from the upper end of the gas discharge flow passage 15 via the gas discharge port 16.

The nozzle member 70 has the space 24 which is open downwardly between the side plate portion 70A and the inclined plate portion 70B. The recovery ports 22 are provided at the openings of the spaces 24. The space 24 constitutes at least a part of the recovery flow passage in the nozzle member 70. The other end of the recovery tube 23 is connected to a part of the recovery flow passage (space) 24.

The recovery ports 22 recover the liquid LQ for filling the optical path space K1 therewith. The recovery ports 22 are provided at the positions facing the surface of the substrate P over or above the substrate P held by the substrate stage PST. The recovery port 22 is separated by a predetermined distance from the surface of the substrate P. The recovery ports 22 are provided outside the gas discharge ports 16 with respect to the optical path space K1 disposed in the vicinity of the image plane of the projection optical system PL in the X axis direction (non-scanning direction).

The recovery ports 22 are provided outside the first land surface 75 with respect to the optical path space K1 for the exposure light beam EL in the X axis direction (non-scanning direction). The recovery ports 22 are provided on one side (+X side) and the other side (-X side) in the scanning direction with respect to the first land surface 75 respectively. The recovery ports 22 are provided on the both sides of the second land surfaces 76 in the X axis direction (non-scanning direction). That is, the recovery ports 22 are provided on one side (+X side) and the other side (-X side) of the second land surfaces 76 in the X axis direction (non-scanning direction).

The nozzle member 70 includes porous members 25 each of which has a plurality of holes and which are arranged to cover the recovery ports 22. The porous member 25 may be composed of a mesh member having a plurality of holes. The porous member 25 may be composed of, for example, a mesh member in which a honeycomb pattern is formed by a plurality of substantially hexagonal holes.

The porous member 25 can be formed, for example, such that the punching or boring processing is performed to a plate member as a base material for the porous member formed of, for example, titanium or stainless steel (for example, SUS 316). A porous member made of ceramics can be also used as the porous member 25. In this embodiment, the porous member 25 is formed to have a thin plate-shaped form. The porous member 25 has, for example, a thickness of about 100 $\mu$m.

The porous member 25 has the lower surface 26 facing the substrate P held by the substrate stage PST. The lower surface 26 of the porous member 25 is a part of the lower surface of the nozzle member 70. The lower surface 26 of the porous member 25, which faces the substrate P, is substantially flat. The porous member 25 is provided in the recovery port 22 so that the lower surface 26 is substantially parallel to the surface of the substrate P held by the substrate stage PST (i.e., the XY plane).

The lower surface 26 of the porous member 25 provided in the recovery port 22 is provided at approximately the same position (height) as that of the first land surface 75 with respect to the surface of the substrate P. As described above, the first land surface 75 and the lower surface 26 of the porous member 25 are substantially parallel to the surface of the substrate P held by the substrate stage PST (i.e., XY plane) respectively. The first land surface 75 and the lower surface 26 of the porous member 25 are substantially flush with each other so that they are continued to one another. That is, the -X side edge of the lower surface 26 of the porous member 25 provided on the +X side with respect to the optical path space K1, which is closest to the optical path space K1 for the exposure light beam EL, is provided at approximately the same position (height) as that of the +X side edge of the first land surface 75 with respect to the substrate P. The +X side edge of the lower surface 26 of the porous member 25 provided on the -X side with respect to the optical path space K1, which is closest to the optical path space K1 for the exposure light beam EL, is provided at approximately the same position (height) as that of the -X side edge of the first land surface 75 with respect to the substrate P. The liquid LQ is recovered via the porous member 25 arranged in the recovery port 22. Therefore, it is affirmed that the recovery port 22 is formed on the flat surface (lower surface) 26 which is substantially flush with the first land surface 75.

In this embodiment, as shown in Fig. 3(a), the second land surface 76 is provided to have a shape (trapezoidal shape) which is progressively widened at positions separated farther from the optical path space K1 for the exposure light beam EL in the Y axis direction as viewed in a plan view. The recovery port 22 (porous member 25) is provided to have a shape (trapezoidal shape) which is progressively widened at positions separated farther from the optical path space K1 for the exposure light beam EL in the X axis direction as viewed in a plan view. The recovery port 22 for recovering the liquid LQ is absent in the area extending in the scanning direction of the optical path space K1, i.e., in the area extending in the Y axis direction of the optical path space K1 on the lower surface of the nozzle member 70.

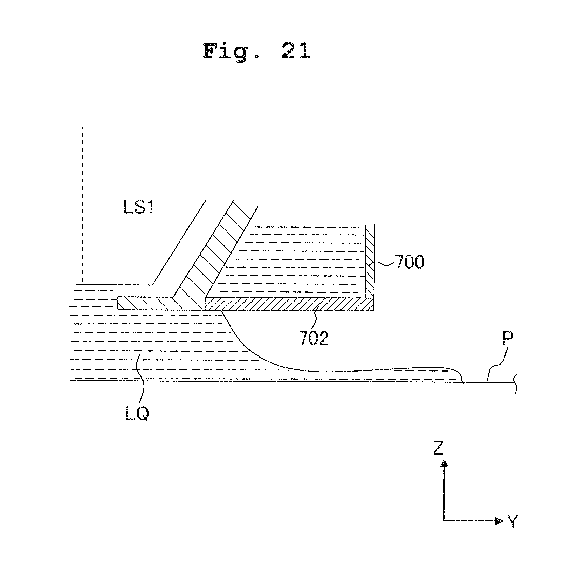

This situation is shown in Fig. 3(b). As conceptually shown in Fig. 3(b), the recovery port is not provided in the extending area EA1 which extends in the scanning direction (Y direction) of the optical path space K1 (approximate to the projection area AR in view of the size). The recovery ports 22 are provided outside the extending area EA1, i.e., on the both sides of the extending area EA1 in the scanning direction (X direction). In the case of this embodiment, the recovery port is not provided in the extending area EA2 which extends in the scanning direction (Y direction) of the first land surface 75 as well. The recovery ports 22 are provided outside the extending area EA2, i.e., on the both sides of the extending area EA2 in the non-scanning direction (X direction). The reason, why the recovery ports 22 are not provided in the extending areas EA1 and EA2 but the recovery ports 22 are provided at the outside thereof, is based on the following knowledge of the inventor. Fig. 21 shows an example of a nozzle member 700 in which a recovery port 702 is provided in the extending area which extends in the scanning direction (Y direction) of the optical path space. The liquid LQ exists in a space between the substrate P and the nozzle member 700. When the substrate P is moved at a high velocity in the scanning direction (+Y direction) by using the nozzle member 700 as described above, then the liquid LQ becomes a thin film on the substrate P in a space between the recovery port 702 and the substrate P, and the liquid LQ on the substrate P sometimes leaks to the outside of the recovery port 702 (+Y side). This phenomenon is caused as follows. That is, the liquid, which is included in the liquid LQ between the recovery port 702 and the substrate P and which is located in the vicinity of the recovery port 702, is recovered by the recovery port 702 provided for the nozzle member 700. However, the liquid, which is located in the vicinity of the surface of the substrate P, is not recovered from the recovery port 702, for example, due to the surface tension with respect to the substrate P, and the liquid becomes the thin film on the substrate P to be pulled out to the outside of the recovery port 702 (outside of the space between the nozzle member 700 and the substrate P) in accordance with the movement of the substrate P. When such a phenomenon arises, the liquid, which is pulled out to the outside of the recovery port 702, forms, for example, droplets to remain on the substrate P, and thereby causes, for example, the pattern defect. However, in this embodiment, the recovery port is not provided in the extending areas EA1 and EA2. Therefore, even when the substrate P is moved at a high velocity in the scanning direction (Y direction), the liquid LQ is suppressed for the formation of the thin film on the substrate P. It is possible to avoid the inconvenience which would be otherwise caused, for example, such that the liquid LQ (for example, droplets) remains on the substrate P.

As described above, the second land surfaces 76 are provided in the predetermined areas of the lower surface of the nozzle member 70 in the Y axis direction with respect to the optical path space K1 for the exposure light beam EL. The recovery ports 22 are provided in the predetermined areas of the lower surface of the nozzle member 70 in the X axis direction with respect to the optical path space K1 for the exposure light beam EL. The recovery ports 22 are provided at the positions different from those of the second land surfaces 76. Although the recovery ports 22 (lower surfaces 26 of the porous members 25) are provided to be substantially flush with the first land surface 75, the recovery port 22 is not provided on the first land surface 75. That is, the recovery ports 22 are provided at the positions other than the areas between the optical path space K1 and the second land surfaces 76 provided outside the first land surface 75 with respect to the optical path space K1 in the Y axis direction. In other words, the recovery port 22 is absent on the second land surfaces 76 provided in the Y axis direction with respect to the optical path space K1 (opening 74), and the recovery port 22 is also absent on the area of the first land surface 75 in the Y axis direction with respect to the optical path space K1 (opening 74) (the recovery port 22 is absent on both of the first land surface 75 and the second land surfaces 76).

In this embodiment, the porous member 25 is formed of the titanium material, and has the liquid-attracting or lyophilic property (water-attracting property) with respect to the liquid LQ. The porous member 25 may be formed of stainless steel (for example, SUS 316). In this case, the liquid-attracting or lyophilic treatment (surface treatment) may be performed to the surface of the porous member 25 in order to obtain the liquid-attracting or lyopholic property. An example of the liquid-attracting or lyophilic treatment includes a treatment for adhering or depositing chromium oxide onto the porous member 25. Specifically, there are exemplified the "GOLDEP" treatment or the "GOLDEP WHITE" treatment as described above. When the surface treatment as described above is performed, it is possible to suppress the elution of any impurity from the porous member 25 to the liquid LQ. Of course, the porous member 25 may be formed of a liquid-attracting or lyophilic material.

Next, an explanation will be made about a method for projecting the pattern image of the mask M onto the substrate P by using the exposure apparatus EX constructed as described above.

In order to fill the optical path space K1 for the exposure light beam EL with the liquid LQ, the control unit CONT drives the liquid supply unit 11 and the liquid recovery unit 21 respectively. The liquid LQ, which has been fed from the liquid supply unit 11 under the control of the control unit CONT, is allowed to flow through the supply tube 13, and then the liquid LQ is supplied from the supply ports 12 via the supply flow passages 14 of the nozzle member 70 to the internal space G2 between the bottom plate portion 70D and the final optical element LS1 of the projection optical system PL. The liquid LQ, which has been supplied to the internal space G2 from the supply ports 12, is allowed to flow while being spread on the upper surface 77 of the bottom plate portion 70D, and the liquid LQ arrives at the opening 74. By supplying the liquid LQ to the internal space G2, the gas portion, which has been present in the internal space G2, is discharged to the external space K3 via the gas discharge ports 16 and/or the opening 74. Therefore, it is possible to avoid the inconvenience which would be otherwise caused such that the gas remains or stays in the internal space G2 upon the start of the supply of the liquid LQ to the internal space G2. It is possible to avoid the inconvenience which would be otherwise caused such that any gas portion (bubble) is formed in the liquid LQ in the optical path space K1.

In this embodiment, the recesses 78 are provided in the vicinity of the gas discharge ports 16 disposed on the upper surface 77 of the bottom plate portion 70D. Accordingly, even when the gap between the lower surface T1 of the final optical element LS1 and the upper surface 77 of the bottom plate portion 70D, is small, the gas portion contained in the internal space G2 can be smoothly discharged to the external space K3 via the recesses 78 and the gas discharge ports 16, because the flow passages disposed in the vicinity of the gas discharge ports 16 are broadened by the recesses 78.

In this arrangement, the upper end of the gas discharge flow passage 15 is connected to the atmospheric space (external space) K3 to be in the state of being open to the atmospheric air. However, the upper end of the gas discharge flow passage 15 may be connected to a suction unit such as a vacuum system or the like to forcibly discharge the gas contained in the internal space G2.

In addition, the liquid LQ may be supplied to the internal space G2 from the ports (gas discharge ports) 16 provided on the both sides in the X axis direction with respect to the optical path space K1. Further, the gas portion contained in the internal space G2 may be discharged to the external space K3 from the ports (supply ports) 12 provided on the both sides in the Y axis direction with respect to the optical path space K1.

After the internal space G2 is filled with the liquid LQ supplied to the internal space G2, the liquid LQ is allowed to flow via the opening 74 into the space between the first land surface 75 and the substrate P (substrate stage PST) to fill the optical path space K1 for the exposure light beam EL therewith. The optical path space K1 for the exposure light beam EL, which is disposed between the final optical element LS1 (projection optical system PL) and the substrate P, is filled with the liquid LQ by supplying the liquid LQ from the supply ports 12 to the internal space G2 between the final optical element LS1 and the bottom plate portion 70D as described above.

In this situation, the liquid recovery unit 21, which is driven under the control of the control unit CONT, recovers a predetermined amount of the liquid LQ per unit time. The liquid recovery unit 21, which includes the vacuum system, can recover the liquid LQ existing between the recovery ports 22 (porous members 25) and the substrate P via the recovery ports 22 by providing the negative pressure in the space 24. The liquid LQ, with which the optical path space K1 for the exposure light beam EL is filled, is allowed to flow into the recovery flow passages 24 via the recovery ports 22 of the nozzle member 70. The liquid LQ is allowed to flow through the recovery tube 23, and then the liquid LQ is recovered by the liquid recovery unit 21.

As described above, the control unit CONT uses the liquid immersion mechanism 1 so that the predetermined amount per unit time of the liquid LQ is supplied to the optical path space K1, and the predetermined amount per unit time of the liquid LQ is recovered from the optical path space K1. Accordingly, the liquid immersion area LR can be locally formed on the substrate P with the liquid LQ for filling the optical path space K1 for the exposure light beam EL between the projection optical system PL and the substrate P and the liquid LQ in a space between the nozzle member 70 and the substrate P. The control unit CONT projects the pattern image of the mask M onto the substrate P via the projection optical system PL and the liquid LQ in the optical path space K1 while relatively moving the projection optical system PL and the substrate P in the state in which the optical path space K1 for the exposure light beam EL is filled with the liquid LQ. As described above, the exposure apparatus EX of this embodiment is the scanning type exposure apparatus in which the Y axis direction is the scanning direction. Therefore, the control unit CONT controls the substrate stage PST so that the substrate P is exposed by radiating the exposure light beam EL onto the substrate P while moving the substrate P at a velocity of 500 to 700 mm/sec. in the Y axis direction.

There is the following possibility in the scanning type exposure apparatus as described above depending on the structure of the nozzle member. That is, for example, it is impossible to sufficiently recover the liquid LQ via the recovery ports 22 as the scanning velocity (movement velocity) of the substrate P is increased to be high, and the liquid LQ, which has been filled in the optical path space K1, may leak to the outside of the space between the substrate P and the nozzle member 70.

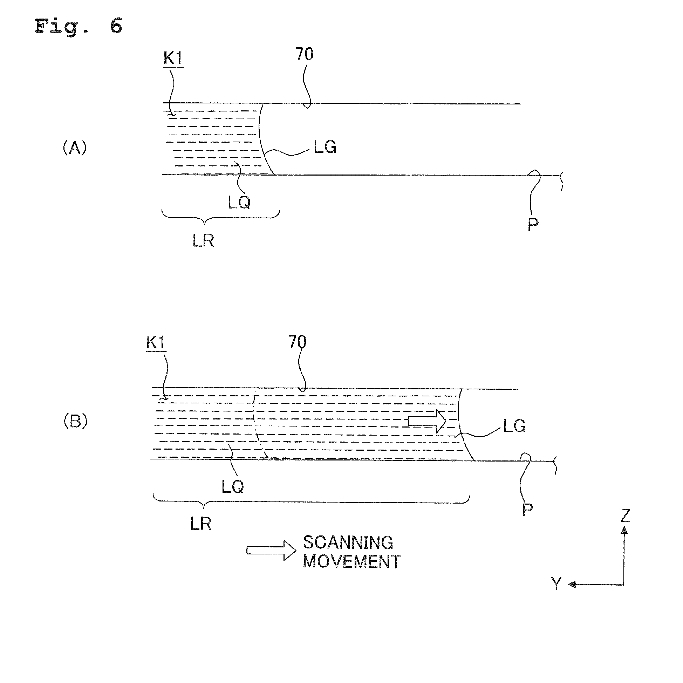

For example, as shown in Fig. 6, in the case that the entire area of the lower surface of the nozzle member 70 extending in the scanning direction (Y axis direction) of the optical path space K1 is provided substantially in parallel to the surface of the substrate P (XY plane), when the substrate P is moved in the scanning direction (Y axis direction) with respect to the liquid immersion area LR (nozzle member 70), then the movement distance and/or the movement velocity of the interface (gas-liquid interface) between the liquid LQ in the liquid immersion area LR and the outside space thereof is increased, and there is such a possibility that the liquid LQ may leak. That is, it is assumed that the substrate P is moved in the -Y direction at a predetermined velocity by a predetermined distance with respect to the liquid immersion area LR from the first state as schematically shown in Fig. 6(A) to give the second state brought during the movement of the substrate P as shown in Fig. 6(B). On this assumption, when the movement velocity (scanning velocity) of the substrate P is increased to be high, then the movement distance and/or the movement velocity of the interface LG between the liquid LQ of the liquid immersion area LR and the outside space thereof is increased, and the liquid immersion area LR is expanded. There is such a possibility that the liquid LQ in the liquid immersion area LR may leak to the outside of the recovery port 22.

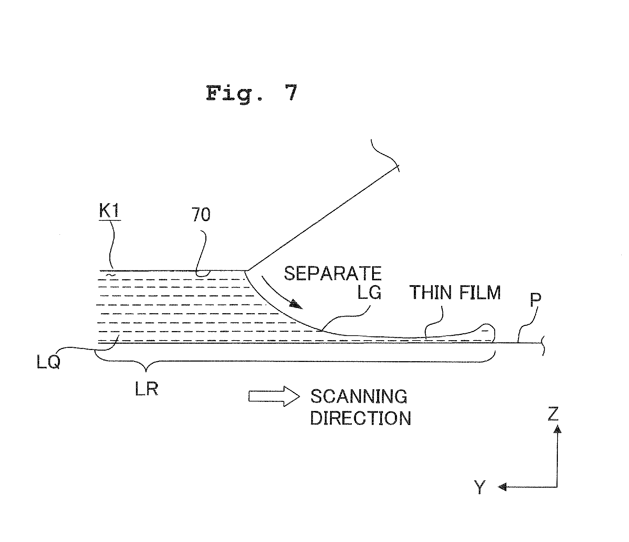

On the other hand, as schematically shown in Fig. 7, in the case that the lower surface of the nozzle member 70 is formed with a flat portion which is parallel to the XY plane and an inclined surface portion which extends in the Y axis direction of the flat portion and which has a large angle (for example, 50°) with respect to the XY plane, when the substrate P is moved in the -Y direction at a predetermined velocity by a predetermined distance with respect to the liquid immersion area LR, then a part of the liquid LQ existing between the substrate P and the lower surface of the nozzle member 70 is separated (exfoliated) from the lower surface of the nozzle member 70 at the stepped portion (boundary between the flat portion and the inclined surface portion), and there is such a possibility that the thin film of the liquid LQ may be formed on the substrate P. Since the thin film of the liquid LQ is separated from the recovery port 22 (porous member 25), even when the thin film portion of the liquid LQ is present at or moved to the position located just under the recovery port 22, there is such a possibility that a situation may arise in which the thin film portion cannot be recovered by the recovery port 22. In such a situation, there is such a possibility that the liquid LQ may leak to the outside of the space between the substrate P and the nozzle member 70, and/or the liquid LQ may remain on the substrate P. There is a high possibility that the thin film of the liquid LQ is formed on the substrate P as the movement velocity of the substrate P is increased to be high. Therefore, there is such a high possibility that the liquid LQ cannot be recovered sufficiently via the recovery port 22 as the movement velocity of the substrate P is increased to be high. As described above, there is such a possibility that the liquid LQ may become the thin film on the substrate P, and droplets or the like of the liquid LQ may remain on the substrate P, even when the recovery port 22 is not formed on the lower surface of the nozzle member 70 extending in the scanning direction (Y axis direction) of the optical path space K1.

Accordingly, in this embodiment, the state of the lower surface of the nozzle member 70 facing the substrate P is optimized so that the liquid LQ is not separated from the lower surface of the nozzle member 70 and the expansion of the liquid LQ is suppressed, even when the substrate P is moved. Specifically, in this embodiment, the positional relationship between the first land surface 75 and the second land surfaces 76 and/or the respective surface states of the first land surface 75 and the second land surfaces 76 are optimized.

As described above, the first land surface 75 is the flat surface which is substantially parallel to the surface of the substrate P, and the first land surface 75 has the liquid-attracting or lyophilic property. The liquid LQ, which exists between the surface of the substrate P and the first land surface 75, makes tightly contact with the first land surface 75, and the liquid LQ for filling the optical path space K1 for the exposure light beam EL therewith, is satisfactorily retained between the surface of the substrate P and the first land surface 75. The second land surface 76 is the inclined surface in which the distance with respect to the substrate P is increased at positions separated farther from the optical path space K1 for the exposure light beam EL in the Y axis direction. The second land surface 76 has the liquid-attracting or lyophilic property. Further, the angle $\theta_A$, which is formed by the first land surface 75 and the second land surface 76, is set to be not more than 10 degrees. The second land surfaces 76 are provided continuously to the first land surface 75. Further, the recovery port 22 is not provided for the second land surface 76. The recovery port 22 is not provided in the scanning direction (Y axis direction) of the first land surface 75 with respect to the optical path space K1 as well. When the nozzle member 70, in which the positional relationship between the first land surface 75 and the second land surfaces 76 and/or the respective surface states of the first land surface 75 and the second land surfaces 76 are optimized as described above, is used, then the expansion of the liquid immersion area LR can be suppressed, and the liquid LQ, which exists between the surface of the substrate P and the second land surface 76, can be prevented from being separated (exfoliated) from the second land surfaces 76, even when the substrate P is moved in the state in which the optical path space K1 for the exposure light beam EL is filled with the liquid LQ.

When the positional relationship of the first land surface 75 and the second land surface 76 is not optimized, there is such a possibility that it is difficult to allow the liquid LQ to make tightly contact with the lower surface of the nozzle member 70. When the recovery port 22 is provided in the first land surface 75 and/or the second land surface 76 disposed in the Y axis direction with respect to the optical path space K1 (opening 74), the surface state of the lower surface of the nozzle member 70 is changed. There is such a possibility that the liquid LQ may be separated from the lower surface of the nozzle member 70 as described above. In this embodiment, the positional relationship of the first land surface 75 and the second land surface 76 is optimized, and the recovery port 22 is not provided on the side in the scanning direction (Y axis direction) of the optical path space K1 (opening 74). Therefore, the liquid LQ can be satisfactorily retained with respect to the substrate P by the first land surface 75 and the second land surface 76. It is possible to suppress the occurrence of the phenomenon which would be otherwise caused such that the thin film of the liquid LQ is formed as explained with reference to Figs. 7 and 21. It is possible to avoid the leakage and the remaining of the liquid LQ.

The second land surface 76 is provided at the position separated farther from the surface of the substrate P than the first land surface 75. The recovery port 22 is absent on the side in the scanning direction (Y axis direction) of the optical path space K1 of the lower surface of the nozzle member 70. Therefore, it is possible to suppress the movement velocity and the movement distance of the interface of the liquid immersion area LR, and it is possible to suppress the expansion (enormous expansion) of the liquid immersion area LR.

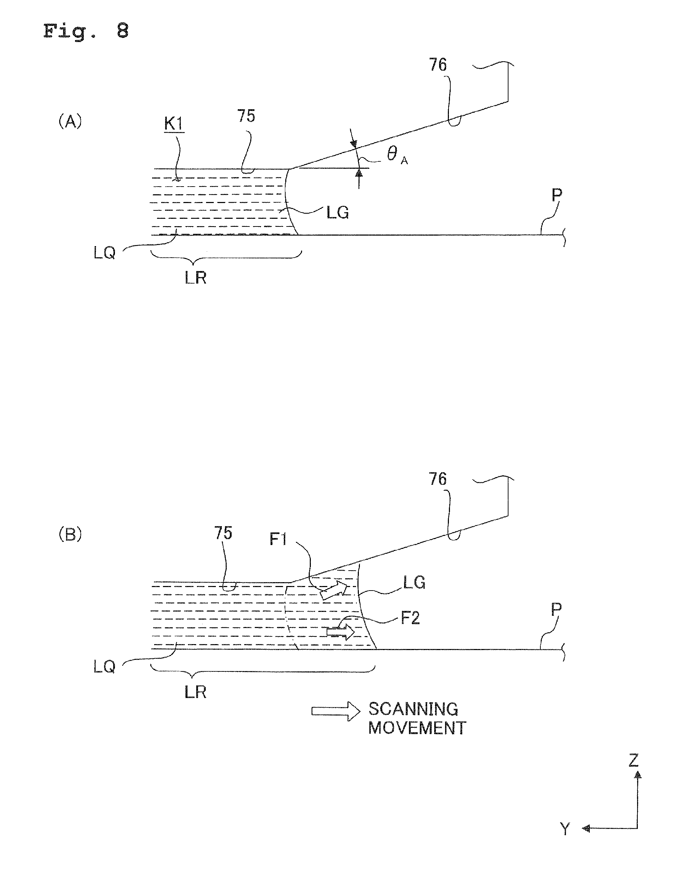

Fig. 8 schematically explains the behavior of the liquid immersion area LR when the substrate P is moved in the Y axis direction. When the substrate P is moved in the -Y direction at a predetermined velocity by a predetermined distance with respect to the liquid immersion area LR from the first state shown in Fig. 8(A) (state in which the liquid LQ is retained between the first land surface 75 and the substrate P), the second state is given as shown in Fig. 8(B). The distance between the second land surface 76 and the substrate P is larger than the distance between the first land surface 75 and the substrate P. The space between the second land surface 76 and the substrate P is larger than the space between the first land surface 75 and the substrate P. Therefore, the component F1 to move in the upward direction and the component F2 to move in the horizontal direction are generated in the liquid LQ of the liquid immersion area LR in the second state which is provided during the movement of the substrate P as shown in Fig. 8(B). Specifically, the component F1 is the component to move obliquely upwardly along the second land surface 76. Therefore, when the substrate P is moved, it is possible to relatively decrease the distance between the interface LG brought about in the first state as shown in Fig. 8(A) and the interface LG brought about in the second state during the movement of the substrate P as shown in Fig. 8(B). Therefore, it is possible to suppress the expansion (enormous expansion) of the liquid immersion area LR. The angle $\theta_A$, which is formed by the first land surface 75 and the second land surface 76, is small, i.e., not more than 10 degrees. Therefore, even when the substrate P is moved at a high velocity with respect to the liquid immersion area LR, it is possible to suppress any large change of the shape of the interface LG.

As explained with reference to Figs. 6, 7, and 21, the phenomenon which causes the leakage of the liquid LQ, i.e., the phenomenon in which, for example, the movement distance and/or the movement velocity of the interface LG of the liquid immersion area LR is increased and/or the liquid LQ is separated from the lower surface of the nozzle member 70, tends to arise in the scanning direction (Y axis direction) in which the substrate P is moved at the high velocity. Therefore, when by optimizing the state of the area on the side in the Y axis direction of the optical path space K1 of the lower surface of the nozzle member 70 so that, for example, the leakage and the like of the liquid LQ can be suppressed, it is possible to suppress the leakage of the liquid LQ, even when the substrate P is exposed while moving the substrate P in the Y axis direction.

The substrate P (substrate stage PST) is not only moved in the Y axis direction but also the substrate P is frequently moved in the X axis direction during the exposure of a plurality of shot areas on the substrate P. Therefore, when the recovery port 22 for recovering the liquid LQ is provided on the side in the X axis direction with respect to the optical path space K1, then the liquid LQ can be recovered, and it is possible to suppress the expansion of the liquid immersion area LR. In this embodiment, the lower surface 26 of the porous member 25 provided for the recovery port 22 is provided substantially in parallel to the surface of the substrate P. The lower surface 26 of the porous member 25 of the recovery port 22 is substantially flush with the first land surface 75. Therefore, the recovery port 22 (lower surface 26 of the porous member 25) is arranged at the position near to the substrate P. Therefore, the recovery port 22 can recover the liquid LQ satisfactorily and efficiently.

As explained above, the nozzle member 70 has the first land surface 75, and the second land surfaces 76 which are provided at the positions separated farther from the surface of the substrate P than the first land surface 75. Accordingly, it is possible to suppress the size of the liquid immersion area LR from becoming very large. Therefore, it is possible to avoid the size of the nozzle member 70 from becoming very large, the size of the substrate stage PST from becoming very large, and the increase in the movement stroke of the substrate stage PST, with the increase of the size of the liquid immersion area LR. Consequently, it is possible to avoid the size of the entire exposure apparatus EX from becoming very large.

The recovery port 22 is not provided on the second land surface 76 and on an area between the second land surface 76 and the optical path space K1 for the exposure light beam EL (see the extending areas EA1 and EA2 shown in Fig. 3). Accordingly, for example, even when the substrate P is moved in the Y axis direction (scanning direction), the liquid LQ is hardly separated from the lower surface of the nozzle member 70. Therefore, it is possible to avoid the formation of the thin film of the liquid LQ on the substrate P. That is, the recovery port 22 is provided at the position other than the second land surface 76 and at position other than the area between the optical path space K1 for the exposure light beam EL and the second land surface 76 provided at the position separated from the optical path space K1 in the Y axis direction (i.e., at the position other than the predetermined area in the Y axis direction of the first land surface 75 with respect to the optical path space K1). Accordingly, the surface state of the lower surface of the nozzle member 70 in the Y axis direction can be made to be the optimum state in order that the liquid LQ is allowed to make tightly contact. Therefore, even when the substrate P is moved in the Y axis direction, the liquid LQ can be retained satisfactorily between the lower surface of the nozzle member 70 and the surface of the substrate P.

In addition, since the nozzle member 70 has the first land surface 75 which is arranged closely to the surface of the substrate P around the optical path space K1, it is possible to satisfactorily retain the liquid LQ in the space between the nozzle member 70 and the substrate P. Therefore, the optical path space K1 for the exposure light beam EL can be reliably filled with the liquid LQ, for example, during the exposure for the substrate P. It is possible to avoid the occurrence of the state (liquid empty state) in which the liquid LQ disappears from the optical path space K1, i.e., the inconvenience in which the gas portion is formed in the optical path space K1.

In this embodiment, the width D1 of the first land surface 75 in the Y axis direction (scanning direction) is smaller than the width D2 of the opening 74 in the Y axis direction. The width D1 of the first land surface 75 in the Y axis direction is smaller than the width D3 of the first land surface 75 in the X axis direction. As described above, the width D1 of the first land surface 75 in the Y axis direction is decreased to be as small as possible within the range in which the liquid LQ can be retained between the first land surface 75 and the substrate P, allow the first land surface 75 to be compact. Accordingly, it is possible to make the liquid immersion area LR to be compact, which is formed corresponding to the first land surface 75. Therefore, it is possible to realize the compact size of the entire exposure apparatus EX.

In this embodiment, since the nozzle member 70 has the gas discharge ports 16, it is possible to suppress the inconvenience which would be otherwise caused such that the bubble is formed in the liquid LQ for filling the optical path space K1. Therefore, it is possible to allow the exposure light beam EL to satisfactorily arrive at the substrate P.

In this embodiment, the second land surface 76 is provided to have the trapezoidal shape which is progressively widened at positions separated farther from the optical path space K1 in the Y axis direction as viewed in a plan view. The recovery port 22 (porous member 25) is provided to have the trapezoidal shape which is progressively widened at positions separated farther from the optical path space K1 in the X axis direction as viewed in a plan view. However, it is also allowable to use other shapes as shapes of the second land surface 76 and the recovery port 22. For example, the second land surface 76 may be formed to have a rectangular shape as viewed in a plan view, which has the same width as the width of the optical path space K1 (opening 74) in the X axis direction. The area of the lower surface of the nozzle member 70 except for the area, in which the second land surfaces 76 having the rectangular shapes as viewed in a plan view are provided, can be used as the recovery port 22. Also in this arrangement, the recovery port 22 is provided at the position other than (different from) the second land surface 76, and at the position other than the area between the second land surface 76 and the optical path space K1 (opening 74) for the exposure light beam EL. The recovery port 22 for recovering the liquid LQ is absent in the area (extending area EA1) on the side in the Y axis direction of the optical path space K1. Even in the case of the arrangement as described above, it is possible to avoid the size of the liquid immersion area LR from becoming very large and the liquid LQ from leaking out when the substrate P is subjected to the exposure while moving the substrate P in the Y axis direction.

In this embodiment, although the second land surface 76 is the flat surface, the second land surface 76 may be a curved surface.

Alternatively, the second land surface 76 may be a combination of a plurality of flat surfaces. For example, the following arrangement is also available. That is, a first flat surface, which has a predetermined angle $\theta1$ with respect to the first land surface 75, may be formed as a part of the second land surface 76 outside the first land surface 75 with respect to the optical path space K1. Further, a second flat surface, which has a predetermined angle $\theta2$ ($\theta1 \neq \theta2$, for

example, θ1 = 4 °, θ2 = 0°) with respect to the first land surface 75, may be formed as a part of the second land surface 76 outside the first flat surface with respect to the optical path space K1.

In this embodiment, although the recovery ports 22 (porous members 25) are provided one by one on the both sides of the lower surface of the nozzle member 70 in the X axis direction with respect to the first land surface 75, the recovery port 22 (porous member 25) may be divided into a plurality of parts.

In this embodiment, although the width D1 of the first land surface 75 in the Y axis direction is smaller than the width D2 of the opening 74 in the Y axis direction, the width D1 of the first land surface 75 in the Y axis direction may be made larger than the width D2 of the opening 74 in the Y axis direction. In addition, in this embodiment, although the outer shape of the first land surface 75 is the rectangular shape (oblong shape) in which the X axis direction is the longitudinal direction thereof, the outer shape of the first land surface 75 may be any arbitrary shape including, for example, square shape, circular shape or the like.

Second Embodiment

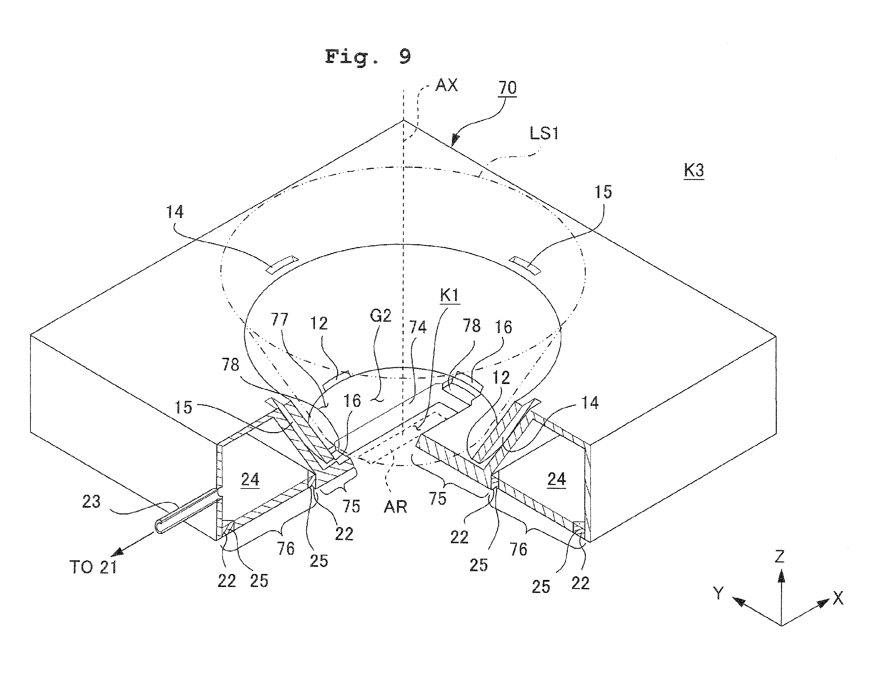

Next, a second embodiment will be explained with reference to Figs. 9 to 12. In the following description, the constitutive portions, which are the same as or equivalent to those of the first embodiment described above, are designated by the same reference numerals, any explanation of which will be simplified or omitted.

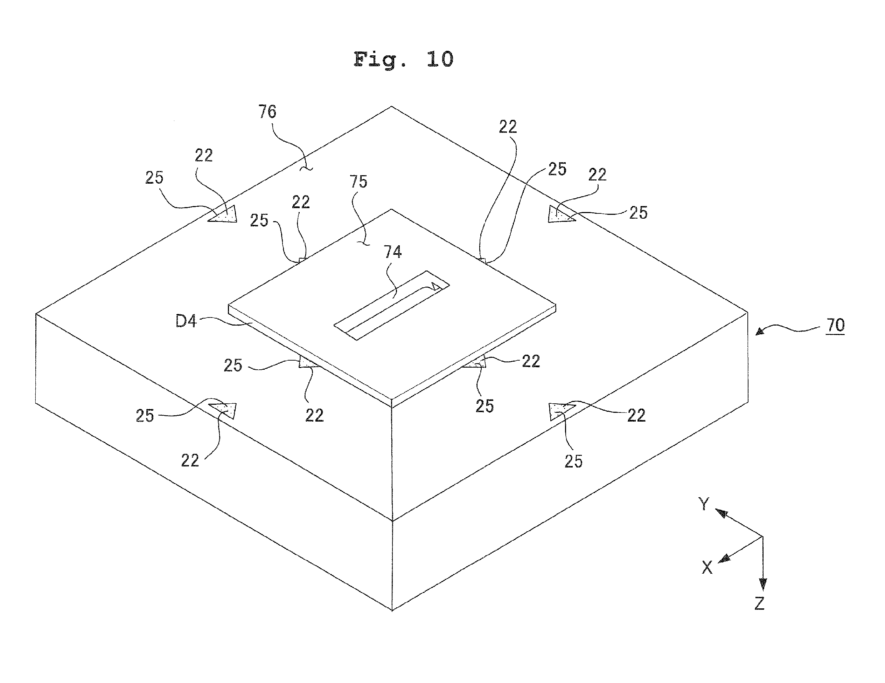

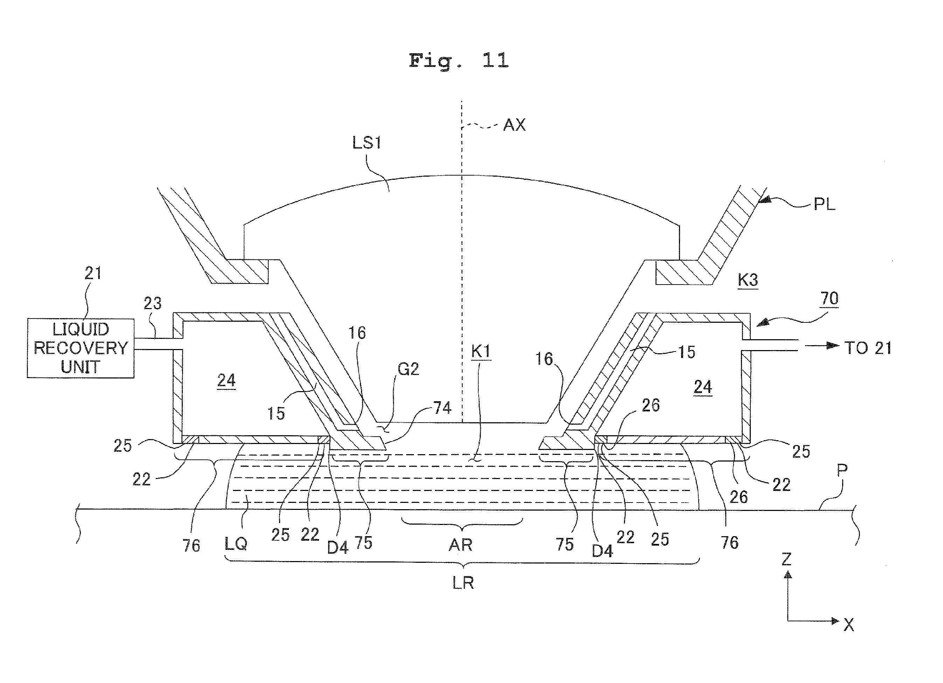

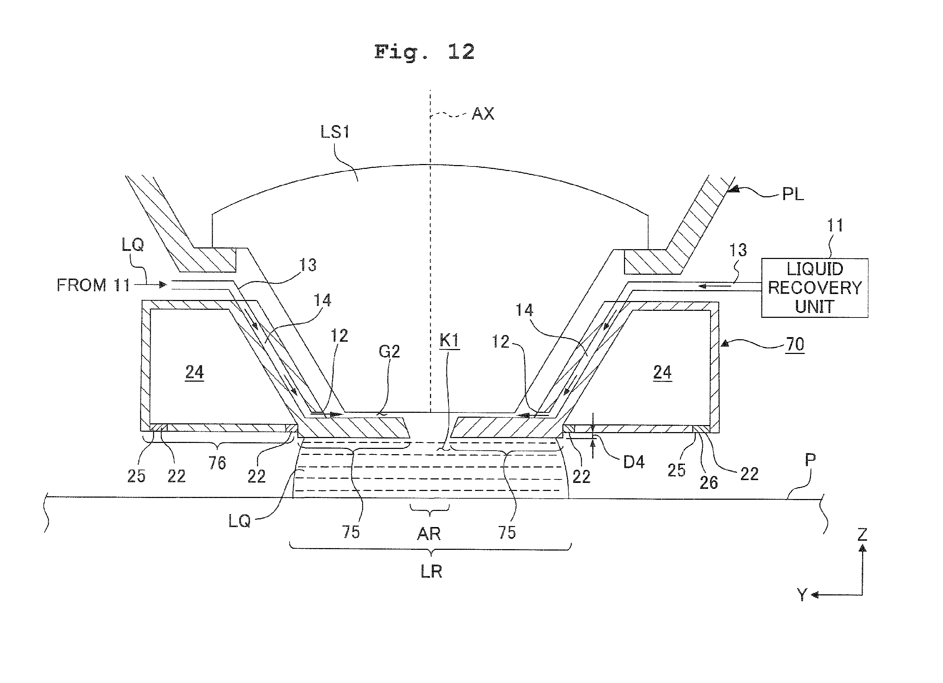

Fig. 9 shows a schematic perspective view with partial cutout, illustrating those disposed in the vicinity of a nozzle member 70 according to the second embodiment. Fig. 10 shows a perspective view illustrating the nozzle member 70 as viewed from the lower side. Fig. 11 shows a side sectional view taken in parallel to the XZ plane. Fig. 12 shows a side sectional view taken in parallel to the YZ plane.

The opening 74, through which the exposure light beam EL is allowed to pass, is formed at the central portion of the bottom plate portion 70D of the nozzle member 70. The opening 74 has a shape according to the projection area AR. The opening 74 is formed to have a slit-shaped form (substantially rectangular form) in which the X axis direction (non-scanning direction) is the longitudinal direction in the same manner as in the first embodiment described above. A first land surface 75 is provided around the opening 74 on the lower surface of the nozzle member 70. The first land surface 75 is provided so that the first land surface 75 faces the surface of the substrate P, and the first land surface 75 surrounds the optical path space K1 for the exposure light beam EL (projection area AR). The first land surface 75 is provided to be substantially in parallel to the surface of the substrate P (XY plane). The first land surface 75 is provided at the position in the nozzle member 70 closest to the substrate P held by the substrate stage PST.

The first land surface 75 is provided to surround the optical path space K1 for the exposure light beam EL (projection area AR) in the space between the substrate P and the lower surface T1 of the projection optical system PL. As described above, the first land surface 75 is provided in a part of the area of the lower surface of the bottom plate portion 70D, and is provided around the opening 74 to surround the opening 74 through which the exposure light beam EL is allowed to pass. As shown in Fig. 10, the outer shape of the first land surface 75 of this embodiment is formed to be substantially square. The opening 74 is provided at a substantially central portion of the first land surface 75. The width of the first land surface 75 in the Y axis direction is larger than the width of the opening 74 in the Y axis direction. The outer shape of the first land surface 75 may be a rectangular shape in which the X axis direction is the longitudinal direction, in the same manner as in the first embodiment described above. The width of the first land surface 75 in the Y axis direction may be smaller than the width of the opening 74 in the Y axis direction. Alternatively, the outer shape of the first land surface 75 may be an arbitrary shape including, for example, circular shape.

The lower surface of the nozzle member 70 has a second land surface 76 which is provided outside the first land surface 75 with respect to the optical path space K1 for the exposure light beam EL, which is provided opposite to the surface of the substrate P held by the substrate stage PST, and which is provided at the position separated farther from the surface of the substrate P than the first land surface 75.

In this embodiment, the second land surface 76 is provided substantially in parallel to the surface of the substrate P (XY plane) at the position separated farther from the surface of the substrate P than the first land surface. A difference in height D4 is provided between the first land surface 75 which is provided substantially in parallel to the surface of the substrate P and the second land surface 76 which is provided substantially in parallel to the surface of the substrate P.

In this embodiment, the second land surface 76 is provided outside the first land surface 75 with respect to the optical path space K1 for the exposure light beam EL in the Y axis direction. Further, the second land surface 76 is provided outside the first land surface 75 with respect to the optical path space K1 of the exposure light beam EL in the X axis direction. That is, in this embodiment, the second land surface 76 is provided to surround the first land surface 75.

Also in this embodiment, the first land surface 75 and the second land surface 76 are in a state of being provided in a predetermined positional relationship so that the liquid LQ, which exists between the surface of the substrate P and the second land surface 76, is not separated from the second land surface 76, when the liquid LQ is present between the surface of the substrate P and the second land surface 76. Specifically, the liquid LQ, which exists between the surface of the substrate P and the second land surface 76, is not separated (exfoliated) from the second land surface 76, even when the substrate P is moved in the Y axis direction in a state in which the optical path space K1 is filled with the liquid LQ.

The difference in height D4 between the first land surface 75 and the second land surface 76 is set to be not more than 1 mm (see Fig. 12). In this embodiment, the difference in height D4 between the first land surface 75 and the second land surface 76 is set to be about 0.5 mm.

The first land surface 75 and the second land surface 76 have liquid-attracting or lyophilic property with respect to the liquid LQ respectively in the same manner as in the first embodiment. The contact angle between the first land surface 75 and the liquid LQ is approximately equal to the contact angle between the second land surface 76 and the liquid LQ.

The nozzle member 70 has supply ports 12 which supply the liquid LQ for filling the optical path space K1 for the exposure light beam EL therewith, and recovery ports 22 which recover the liquid LQ for filling the optical path space K1 for the exposure light beam EL therewith. The supply ports 12 are provided in the vicinity of the internal space G2 between the final optical element LS1 and the upper surface 77, and are connected to the internal space G2. The nozzle member 70 has gas discharge ports 16 for making communication between the internal space G2 and the external space. The gas discharge ports 16 are provided in the vicinity of the internal space G2 between the final optical element LS1 and the upper surface 77, and are connected to the internal space G2. As described in the first embodiment, the evacuation may be forcibly performed from the gas discharge ports 16. In the same manner as in the first embodiment described above, the liquid LQ may be supplied to the internal space G2 from the ports (gas discharge ports) 16 provided on the both sides in the X axis direction with respect to the optical path space K1, and the gas portion of the internal space G2 may be discharged to the external space K3 from the ports (supply ports) 12 provided on the both sides in the Y axis direction with respect to the optical path space K1.

The recovery ports 22 are provided at the positions facing the surface of the substrate P over or above the substrate P held by the substrate stage PST. The recovery ports 22 are separated from the surface of the substrate P by a predetermined distance. The recovery ports 22 are provided outside the supply ports 12 with respect to the optical path space K1 in the vicinity of the image plane of the projection optical system PL.

In this embodiment, the recovery ports 22 are provided on the second land surface 76 as a part of the lower surface of the nozzle member 70. The recovery ports 22 are provided at the plurality of predetermined positions of the second land surface 76 respectively. Each of the recovery ports 22 is provided to be smaller than the size of the exposure light beam EL as viewed in a cross section, i.e., the size of the projection area AR. In this embodiment, the phrase "size of the exposure light beam EL as viewed in a cross section" is the size of the exposure light beam EL as viewed in a cross section in the optical path space K1 between the substrate P and the final optical element LS1, which can be substantially approximated to the size of the projection area AR. As shown in Fig. 10, each of the recovery ports 22 is provided to have a substantially triangular shape as viewed in a plan view in this embodiment. The shape of the recovery port 22 as viewed in a plan view may be an arbitrary shape including, for example, rectangular shape and circular shape. The recovery ports 22 are provided respectively at the plurality of predetermined positions of the second land surface 76 disposed in the Y axis direction with respect to the optical path space K1 (opening 74) and at the plurality of predetermined positions disposed in the X axis direction with respect to the optical path space K1 (opening 74). Specifically, the recovery ports 22 are provided respectively at the position of the second land surface 76 disposed in the vicinity of the +Y side end of the first land surface 75 and at the position away from the foregoing position in the +Y direction with respect to the optical path space K1. The recovery ports 22 are provided respectively at the position disposed in the vicinity of the -Y side end of the first land surface 75 and at the position away from the foregoing position in the -Y direction with respect to the optical path space K1. Further, the recovery ports 22 are provided respectively at the position of the second land surface 76 disposed in the vicinity of the +X side end of the first land surface 75 and at the position away from the foregoing position in the +X direction with respect to the optical path space K1. The recovery ports 22 are provided respectively at the position disposed in the vicinity of the -X side end of the first land surface 75 and at the position separated from the foregoing position in the -X direction with respect to the optical path space K1. That is, in this embodiment, the recovery ports 22 are provided at the eight predetermined positions respectively. The number and the arrangement of the recovery ports 22 may be arbitrarily set provided that the liquid LQ can be recovered so that the liquid LQ is not separated from the second land surface 76. In this embodiment, the size and the shape of each of the recovery ports 22 are equal to one another. However, the size and the shape of each of the recovery ports 22 may be different from each other.

Porous members 25 are arranged in the respective recovery ports 22 respectively in the same manner as in the first embodiment. Each of the porous members 25 has a flat lower surface 26 facing the substrate P held by the substrate stage PST. The porous member 25 is provided in the recovery port 22 so that the lower surface 26 is substantially parallel to the surface of the substrate P held by the substrate stage PST (i.e., the XY plane). The lower surfaces 26 of the porous members 25 provided in the recovery ports 22 and the second land surface 76 are provided at approximately identical positions (heights) with respect to the surface of the substrate P. That is, the second land surface 76 is substantially flush with the lower surfaces 26 of the porous members 25 so that the second land surface 76 is continued to the lower surfaces 26 of the porous members 25. The liquid LQ is recovered via the porous members 25 arranged in the recovery ports 22. Therefore, the recovery ports 22 are formed on the flat surfaces (lower surfaces) 26 which are substantially flush with the second land surface 76. The porous members 25 have liquid-attracting or lyophilic property (water-attracting or lyophilic property) with respect to the liquid LQ, in the same manner as in the first embodiment.

Next, an explanation will be made about a method for projecting the pattern image of the mask M onto the substrate P by using the exposure apparatus EX constructed as described above.

As described above, the first land surface 75 is the flat surface which has the liquid-attracting or lyophilic property and which is substantially parallel to the surface of the substrate P. The liquid LQ, which exists between the surface of the substrate P and the first land surface 75, makes tightly contact with the first land surface 75. Accordingly, the liquid LQ for filling the optical path space K1 for the exposure light beam EL therewith, is satisfactorily retained between the surface of the substrate P and the first land surface 75. The second land surface 76 is provided substantially in parallel to the surface of the substrate P at the position separated farther from the surface of the substrate P than the first land surface 75. The second land surface 76 has the liquid-attracting or lyophilic property. The difference in height D4 between the first land surface 75 and the second land surface 76 is set to be not more than 1 mm. Further, the recovery port 22 is provided to be smaller than the size of the exposure light beam EL as viewed in a cross section. When the nozzle member 70, in which the positional relationship between the first land surface 75 and the second land surface 76 and/or the respective surface states of the first land surface 75 and the second land surface 76 are optimized, is used, then the expansion of the liquid immersion area LR can be suppressed, and the liquid LQ, which exists between the surface of the substrate P and the second land surface 76, can be prevented from being separated from the second land surface 76, even when the substrate P is moved in the state in which the optical path space K1 is filled with the liquid LQ.

That is, also in this embodiment, when the substrate P is moved, the state of the lower surface of the nozzle member 70 facing the substrate P is optimized so that the expansion of the liquid immersion area LR is suppressed, and the liquid LQ is not separated from the lower surface of the nozzle member 70.

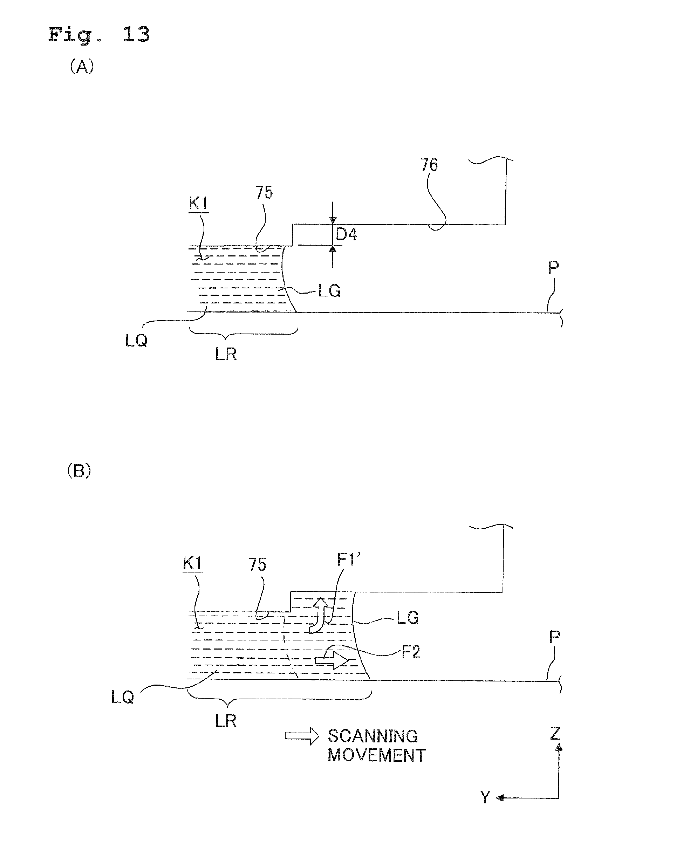

Fig. 13 schematically illustrates the behavior of the liquid immersion area LR when the substrate P is moved in the Y axis direction. When the substrate P is moved in the -Y direction at a predetermined velocity by a predetermined distance with respect to the liquid immersion area LR from the first state shown in Fig. 13(A) (state in which the liquid LQ is retained between the first land surface 75 and the substrate P), the second state is given as shown in Fig. 13(B). The distance between the second land surface 76 and the substrate P is larger than the distance between the first land surface 75 and the substrate P, and the space between the second land surface 76 and the substrate P is larger than the space between the first land surface 75 and the substrate P. Therefore, the component F1' to move in the upward direction and the component F2 to move in the horizontal direction are generated in the liquid LQ of the liquid immersion area LR in the second state in which the substrate P is moved as shown in Fig. 13(B). Therefore, when the substrate P is moved, it is possible to relatively decrease the distance between the interface LG in the first state as shown in Fig. 13(A) and the interface LG in the second state in which the substrate P is moved as shown in Fig. 13(B). Therefore, it is possible to suppress the expansion (enormous expansion) of the liquid immersion area LR. When the difference in height D4 is large, there is such a possibility that the liquid LQ may be exfoliated from the second land surface 76. However, the difference in height D4 is small, i.e., not more than 1 mm. Therefore, it is possible to avoid the formation of the thin film of the liquid LQ on the substrate P by the separation of the liquid LQ from the second land surface 76. Even when the substrate P is moved at a high velocity with respect to the liquid immersion area LR, it is possible to suppress any large change of the shape of the interface LG, because the difference in height D4 is small, i.e., not more than 1 mm.

Although the recovery ports 22 are provided on the second land surface 76, the recovery ports 22 are formed so that the size thereof is sufficiently small to avoid the exfoliation of the liquid LQ from the second land surface 76. Therefore, the surface state of the lower surface of the nozzle member 70 in the Y axis direction is the optimum state to retain the liquid LQ. Therefore, even when the substrate P is moved in the Y axis direction, the liquid LQ can be satisfactorily retained between the substrate P and the lower surface of the nozzle member 70.

Although each of the recovery ports 22 has the small size, the recovery ports 22 are provided at the plurality of predetermined positions on the second land surface 76 respectively. Therefore, it is possible to satisfactorily recover the liquid LQ.

As explained above, it is possible to suppress the enormous expansion of the liquid immersion area LR in this embodiment as well. The recovery ports 22 are provided on the second land surface 76, and the size of each of the recovery ports 22 is made to be as small as possible within the range in which the liquid LQ can be recovered. Accordingly, the surface state of the lower surface of the nozzle member 70 in the Y axis direction can be made to be the optimum state to retain the liquid LQ. Therefore, even when the substrate P is moved in the Y axis direction, the liquid LQ can be satisfactorily retained between the substrate P and the lower surface of the nozzle member 70.

In the second embodiment, the second land surface 76 is provided substantially in parallel to the surface of the substrate P at the position separated farther from the surface of the substrate P than the first land surface 75.

However, the second land surface 76 may be an inclined surface in which the distance with respect to the surface of the substrate P is increased at positions separated farther from the optical path space K1 for the exposure light beam EL in the Y axis direction. The recovery ports 22, which are smaller in size than the projection area AR, may be provided on the second land surface 76 composed of the inclined surface.

In the first embodiment described above, the second land surface 76 is the inclined surface in which the distance with respect to the surface of the substrate P is increased at positions separated farther from the optical path space K1 for the exposure light beam EL in the Y axis direction. However, the second land surface 76 may be provided substantially in parallel to the surface of the substrate P at the position separated farther from the surface of the substrate P than the first land surface 75. The recovery port 22 may be arranged at the position other than the second land surface 76 and at the position other than the space between the optical path space K1 for the exposure light beam EL and the second land surface 76. The size of the recovery port 22 may be made smaller than the size of the exposure light beam EL as viewed in a cross section.

In the respective embodiments described above, for example, the difference in height may be provided between the first land surface 75 and the second land surface 76, and the second land surface 76 may be inclined with respect to the first land surface 75 on condition that the first land surface 75 and the second land surface 76 are provided in the predetermined positional relationship so that the liquid LQ, which exists between the surface of the substrate P and the second land surface 76, is not separated from the second land surface 76.

In the respective embodiments described above, the contact angle between the first land surface 75 and the liquid LQ is approximately equal to the contact angle between the second land surface 76 and the liquid LQ. However, the former may be different from the latter.

This embodiment is illustrative of the case in which the recovery ports are present in the extending areas EA1 and EA2 shown in Fig. 3. However, the size of the recovery port is smaller than the cross-sectional area of the exposure light beam. Therefore, there is little possibility that the thin film of the liquid LQ is formed on the substrate P.

Third Embodiment

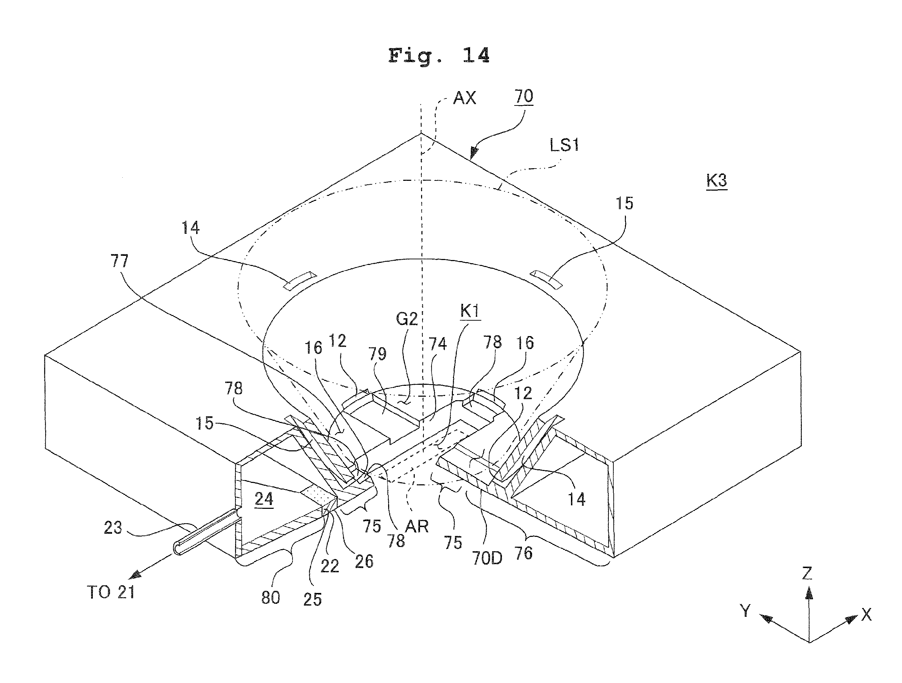

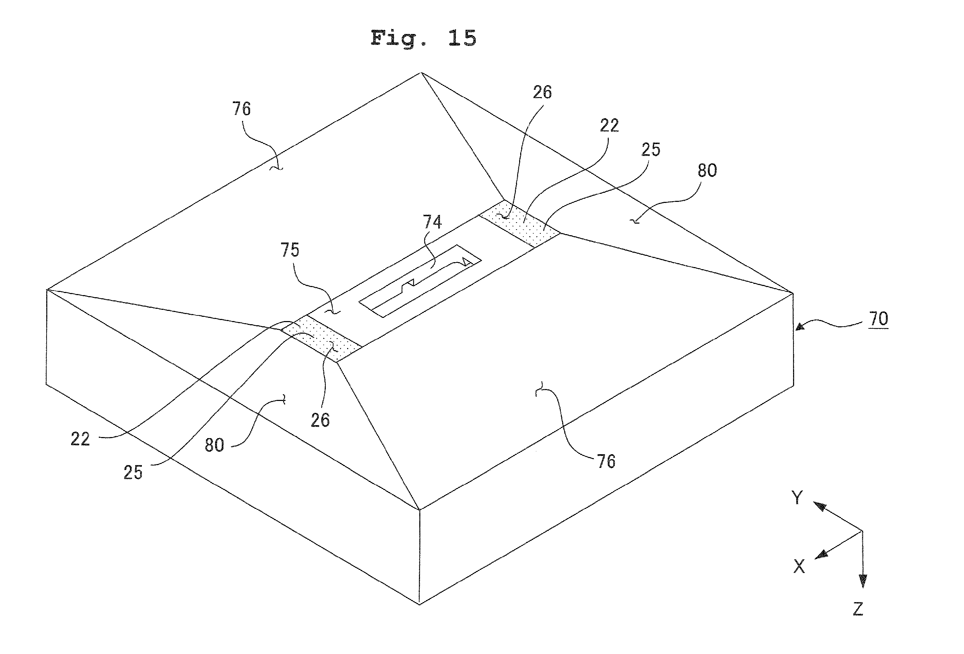

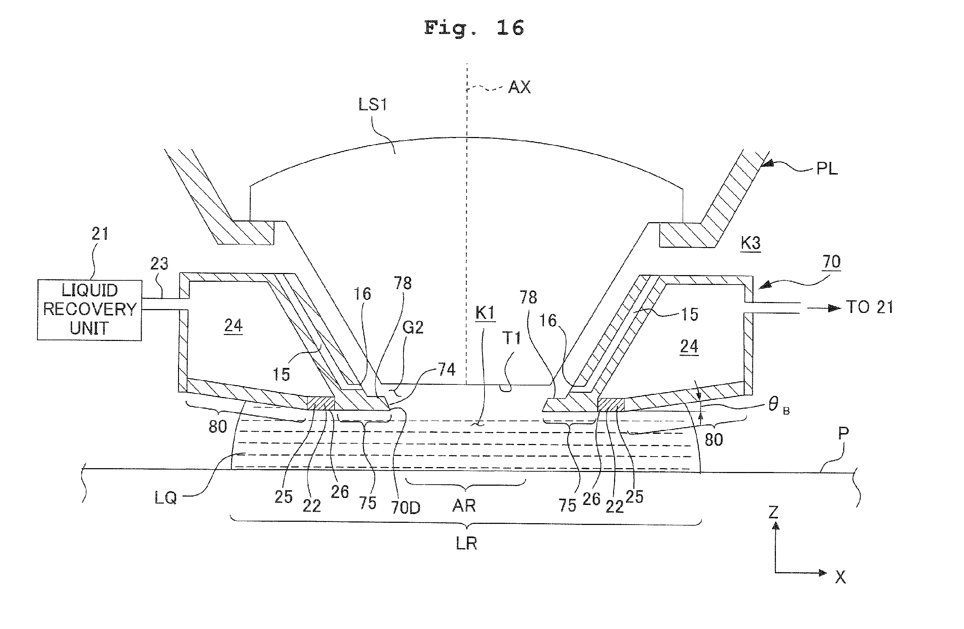

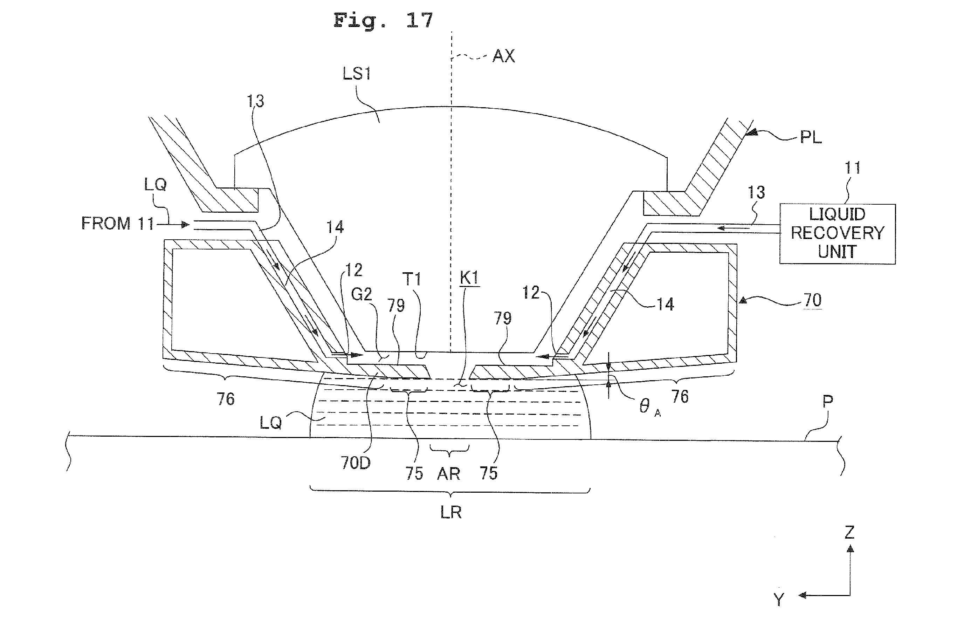

Next, a third embodiment will be explained with reference to Figs. 14 to 17. Fig. 14 shows a schematic perspective view with partial cutout, illustrating the vicinity of a nozzle member 70 according to the third embodiment. Fig. 15 shows a perspective view illustrating the nozzle member 70 as viewed from the lower side. Fig. 16 shows a side sectional view taken in parallel to the XZ plane. Fig. 17 shows a side sectional view taken in parallel to the YZ plane.

The opening 74, through which the exposure light beam EL is allowed to pass, is formed at the central portion of the bottom plate portion 70D of the nozzle member 70. The opening 74 has a shape corresponding to the projection area AR. The opening 74 is formed to have a slit-shaped form in which the X axis direction is the longitudinal direction in the same manner as in the first embodiment described above. A first land surface 75 is provided around the opening 74 on the lower surface of the nozzle member 70. The first land surface 75 is provided so that the first land surface 75 faces the surface of the substrate P, and the first land surface 75 surrounds the optical path space K1 for the exposure light beam EL. The first land surface 75 is provided to be substantially in parallel to the surface of the substrate P (XY plane). In this embodiment, the outer shape of the first land surface 75 is a rectangular shape in which the X axis direction is the longitudinal direction in the same manner as in the first embodiment described above.

The lower surface of the nozzle member 70 has second land surfaces 76 which are provided at positions separated farther from the surface of the substrate P than the first land surface 75, which are provided outside the first land surface 75 with respect to the optical path space K1 for the exposure light beam EL in the Y axis direction, and which are provided opposite to the surface of the substrate P held by the substrate stage PST. In this embodiment, the second land surface 76 is an inclined surface in which the distance with respect to the surface of the substrate P is increased at positions separated farther from the optical path space K1 for the exposure light beam EL in the Y axis direction in the same manner as in the first embodiment described above. The second land surfaces 76 are provided on one side (+Y side) and the other side (-Y side) in the scanning direction with respect to the first land surface 75 respectively. The edges of the second land surfaces 76, which are closest to the optical path space K1, are connected to the edges of the first land surface 75 in the same manner as in the first embodiment described above. The angle $\theta_A$, which is formed by the first land surface 75 and the second land surface 76, is set to be not more than 10 degrees. The first land surface 75 and the second land surfaces 76 have liquid-attracting or lyophilic property with respect to the liquid LQ respectively. The contact angle between the first land surface 75 and the liquid LQ is approximately equal to the contact angle between the second land surface 76 and the liquid LQ. Even when the substrate P is moved in a state in which the optical path space K1 has been filled with the liquid LQ, the liquid LQ, which exists between the surface of the substrate P and the second land surface 76, is not separated from the second land surface 76.

The lower surface of the nozzle member 70 has third land surfaces 80 which are provided at positions separated farther from the surface of the substrate P than the first land surface 75, which are provided outside the first land surface 75 with respect to the optical path space K1 for the exposure light beam EL in the X axis direction, and which are provided opposite to the surface of the substrate P held by the substrate stage PST. The third land surface 80 is an inclined surface in which the distance with respect to the surface of the substrate P is increased at positions separated farther from the optical path space K1 for the exposure light beam EL in the X axis direction. The third land surfaces 80 are provided on one side (+X side) and the other side (-X side) in the direction intersecting with the scanning direction with respect to the first land surface 75 respectively. The angle $\theta_B$, which is formed by the first land surface 75 and the third land surface 80, is set to be, for example, not more than 40 degrees (see Fig. 16).

The third land surface 80 has liquid-attracting or lyophilic property with respect to the liquid LQ. The contact angle between the first land surface 75 and the liquid LQ is approximately equal to the contact angle between the third land surface 80 and the liquid LQ. The first land surface 75 and the third land surfaces 80 are provided in a predetermined positional relationship so that the liquid LQ, which exists between the surface of the substrate P and the third land surface 80, is not separated from the third land surface 80, when the liquid LQ is present between the surface of the substrate P and the third land surface 80. Specifically, the third land surface 80 is formed so that the liquid LQ, which exists between the surface of the substrate P and the third land surface 80, is not separated from the third land surface 80, even when the substrate P is moved in a state in which the optical path space K1 has been filled with the liquid LQ.

As shown in Fig. 15, the second land surface 76 is provided to have a shape (trapezoidal shape) which is progressively widened at positions separated farther from the optical path space K1 for the exposure light beam EL in the Y axis direction as viewed in a plan view. The third land surface 80 is provided to have a shape (trapezoidal shape) which is progressively widened at positions separated farther from the optical path space K1 for the exposure light beam EL in the X axis direction as viewed in a plan view. The edges of the second land surfaces 76 are connected to the edges of the third land surfaces 80.

Recovery ports 22 are provided between the optical path space K1 for the exposure light beam EL and the third land surfaces 80. Specifically, the recovery ports 22 are provided between the first land surface 75 and the third land surfaces 80. Porous members 25 are arranged in the recovery ports 22. In this embodiment, the recovery port 22 is formed to have a rectangular shape as viewed in a plan view. The recovery port 22 is provided to have approximately the same size as that of the first land surface 75 in relation to the Y axis direction.

The porous member 25 has the lower surface 26 facing the substrate P held by the substrate stage PST. The lower surface 26 of the porous member 25, which faces the substrate P, is substantially flat. The porous member 25 is provided in the recovery port 22 so that the lower surface 26 is substantially parallel to the surface of the substrate P held by the substrate stage PST (i.e., the XY plane).

The lower surface 26 of the porous member 25 provided in the recovery port 22 is provided at approximately the same position (height) as that of the first land surface 75 with respect to the surface of the substrate P. The first land surface 75 is substantially flush with the lower surface 26 of the porous member 25 so that the former is continuous to the latter. The +X side edge of the lower surface 26 of the porous member 25 provided on the +X side with respect to the optical path space K1, which is disposed farthest from the optical path space K1 for the exposure light beam EL, is provided at approximately the same position (height) as that of the -X side edge of the third land surface 80 with respect to the substrate P. The -X side edge of the lower surface 26 of the porous member 25 provided on the -X side with respect to the optical path space K1, which is disposed farthest from the optical path space K1 for the exposure light beam EL, is provided at approximately the same position (height) as that of the +X side edge of the third land surface 80 with respect to the substrate P.

As described above, in this embodiment, the recovery port 22 for recovering the liquid LQ is absent in the direction (Y axis direction) parallel to the scanning direction with respect to the optical path space K1, in the same manner as in the first embodiment described above.

Supply ports 12 for supplying the liquid LQ to the optical path space K1 are provided in the vicinity of the internal space G2 between the lower surface T1 of the final optical element LS1 and the upper surface 77 of the bottom plate portion 70D in the same manner as in the first and second embodiments described above. The supply ports 12 are provided at respective predetermined positions on the both sides in the Y axis direction with the optical path space K1 intervening therebetween. Discharge ports 16 for making communication between the internal space G2 and the external space K3 are provided in the vicinity of the internal space G2 between the lower surface T1 of the final optical element LS1 and the upper surface 77 of the bottom plate portion 70D. The gas discharge ports 16 are provided at respective predetermined positions on the both sides in the X axis direction with the optical path space K1 intervening therebetween.

First recesses 79 are provided in the vicinity of the supply ports 12 on the upper surface 77 of the bottom plate portion 70D. Further, second recesses 78 are provided in the vicinity of the gas discharge ports 16 on the upper surface 77 of the bottom plate portion 70D. The first recesses 79 are formed on the upper surface 77 of the bottom plate portion 70D to connect the supply ports 12 and the opening 74. Similarly, the second recesses 78 are formed on the upper surface 77 of the bottom plate portion 70D to connect the gas discharge ports 16 and the opening 74.

Next, an explanation will be made about a method for projecting the pattern image of the mask M onto the substrate P by using the exposure apparatus EX constructed as described above.

In order to fill the optical path space K1 for the exposure light beam EL with the liquid LQ, the control unit CONT drives the liquid supply unit 11 and the liquid recovery unit 21 respectively. The liquid LQ, which is fed from the liquid supply unit 11 under the control of the control unit CONT, is supplied from the supply ports 12 to the internal space G2. In this embodiment, the first recesses 79 are provided on the upper surface 77 of the bottom plate portion 70D. Therefore, the liquid LQ, which is supplied from the supply ports 12, is allowed to flow smoothly to the opening 74 via the upper surface 77 including the first recesses 79. When the liquid LQ is supplied to the internal space G2, the gas portion, which has been present in the internal space G2, is discharged to the external space K3 via the gas discharge ports 16 and/or the opening 74. In this embodiment, the second recesses 78 are provided in the vicinity of the gas discharge ports 16 on the upper surface 77 of the bottom plate portion 70D. Therefore, the gas portion of the internal space G2 can be smoothly discharged to the external space K3 via the second recesses 78 and the gas discharge ports 16. Also in this embodiment, a suction unit such as a vacuum system may be connected to the upper ends of the gas discharge flow passages 15 to forcibly discharge the gas contained in the internal space G2.

The liquid LQ may be supplied to the internal space G2 from the ports (gas discharge ports) 16 provided in the X axis direction with respect to the optical path space K1. Further, the gas portion of the internal space G2 may be discharged to the external space K3 from the ports (supply ports) 12 provided in the Y axis direction with respect to the optical path space K1. Also in this case, by the first recesses 79 and the second recesses 78, the liquid LQ can be allowed to flow smoothly, and the gas contained in the internal space G2 can be discharged smoothly by the first recesses 79 and the second recesses 78.

After the optical path space K1 is filled with the liquid LQ, the control unit CONT radiates the exposure light beam EL onto the substrate P through the liquid LQ while moving the substrate P in the Y axis direction with respect to the optical path space K1. The nozzle member 70 has the second land surfaces 76. Therefore, it is possible to suppress the leakage of the liquid LQ even when the substrate P is exposed while moving the substrate P in the Y axis direction.

Even when the substrate P is moved in the X axis direction with respect to the optical path space K1, it is possible to suppress the leakage of the liquid LQ, because the nozzle member 70 has the third land surfaces 80. The liquid LQ can be retained satisfactorily between the surface of the substrate P and the nozzle member 70 by the third land surfaces 80. Accordingly, it is possible to suppress the occurrence of the phenomenon in which the thin film of the liquid LQ is formed as explained with reference to Fig. 7. It is also possible to suppress the leakage and the remaining of the liquid LQ. The liquid LQ can be recovered satisfactorily via the recovery ports 22 provided between the optical path space K1 (first land surface 75) and the third land surfaces 80. The lower surface 26 of the recovery port 22 can be made sufficiently contact with the liquid LQ, because the lower surfaces 26 of the recovery ports 22 are substantially flush with the first land surface 75. As a result, it is possible to satisfactorily recover the liquid LQ by the recovery ports 22.

As explained above, also in this embodiment, it is possible to suppress the enormous expansion of the liquid immersion area LR, and the optical path space K1 for the exposure light beam EL can be filled with the liquid LQ in a desired state.

In the third embodiment, the third land surface 80 is provided to have the trapezoidal shape which is progressively widened at positions separated farther from the optical path space K1 in the Y axis direction as viewed in a plan view. However, the third land surface 80 may have another shape including, for example, rectangular shape or the like as viewed in a plan view. Similarly, the second land surface 76 may have another shape including, for example, rectangular shape as viewed in a plan view.

In the third embodiment, the third land surface 80 is the flat surface. However, the third land surface 80 may be a curved surface. Alternatively, the third land surface 80 may be a combination of a plurality of flat surfaces. Similarly, the second land surface 76 may be also a curved surface or a combination of a plurality of flat surfaces.

In the third embodiment, the second land surface 76 is the inclined surface in which the distance with respect to the surface of the substrate P is increased at positions separated farther from the optical path space K1 for the exposure light beam EL in the Y axis direction, and the third land surface 80 is the inclined surface in which the distance with respect to the surface of the substrate P is increased at positions separated farther from the optical path space K1 for the exposure light beam EL in the X axis direction. However, either the second land surface 76 or the third land surface 80 may have a difference in height with respect to the first land surface 75 as explained in the second embodiment.

In the third embodiment, the recovery ports 22 (porous members 25) are provided one by one on the both sides in the X axis direction with respect to the first land surface 75 of the lower surface of the nozzle member 70 respectively. However, the recovery port 22 (porous member 25) may be divided into a plurality of parts. The recovery port 22 may be provided to a part of the second land surface 76 and/or the third land surface 80.

In the third embodiment, the outer shape of the first land surface 75 is the rectangular shape in which the X axis direction is the longitudinal direction. However, the outer shape of the first land surface 75 may be an arbitrary shape including, for example, square shape, circular shape or the like.

In the third embodiment, the contact angle between the first land surface 75 and the liquid LQ is approximately equal to the contact angle between the second land surface 76 and the liquid LQ. However, the former and the latter may be different from each other. Similarly, the contact angle between the first land surface 75 and the liquid LQ may be different from the contact angle between the third land surface 80 and the liquid LQ.

Fourth Embodiment

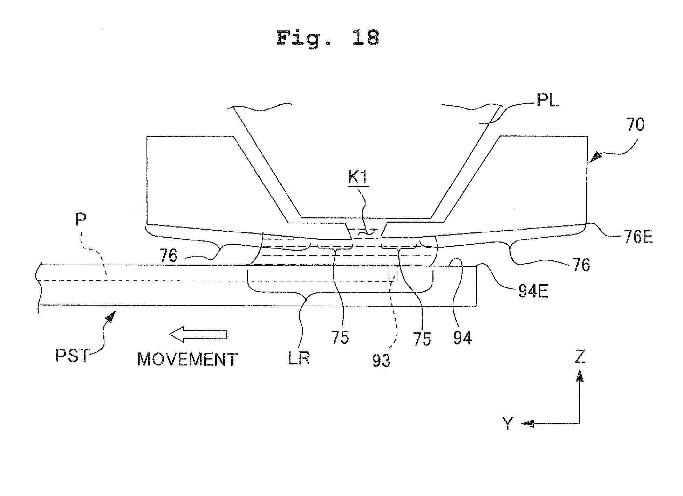

Next, a fourth embodiment will be explained with reference to Fig. 18. Fig. 18 schematically shows the positional relationship between the nozzle member 70 and the substrate stage PST. As for the nozzle member 70, this embodiment will be explained as exemplified by the nozzle member 70 illustrated in the first embodiment described above by way of example.

As shown in Fig. 18, the substrate stage PST has an upper surface 94 which is movable while holding the substrate P and which is capable of retaining the liquid LQ between the first land surface 75 and the second land surface 76 around the substrate P. As described above, the first land surface 75 and the second land surfaces 76 are provided so that the liquid LQ can be retained between at least one of the upper surface 94 of the substrate stage PST and the surface of the substrate P, and the first land surface 75 and the second land surface 76. The movable range of the substrate stage PST is set so that the end 94E of the upper surface 94 of the substrate stage PST is movable to the position nearer to the optical path space K1 for the exposure light beam EL as compared with the end 76E of the second land surface 76 in a state in which the liquid immersion area LR is formed on at least one of the surface of the substrate P held by the substrate stage PST and the upper surface 94 of the substrate stage PST in the Y axis direction (scanning direction).

The reason, why the such position control of the substrate stage is set, is based on the following finding made by the present inventor. The liquid immersion area is formed by supplying the liquid to the space between the substrate P and the upper surface 94 of the substrate stage PST, and the member such as the nozzle member 70. As shown in Fig. 18, it has been hitherto considered that the liquid of the liquid immersion area LR spills out of the substrate stage PST, for example, in a situation in which a part of the lower surface of the nozzle member 70 does not face any one of the surface of the substrate P and the upper surface 94 of the substrate stage PST. Therefore, until now, the edge 94E of the upper surface 94 of the substrate stage PST is never positioned at the inside of the end 76E of the nozzle member 70 (of the second land surface 76), i.e., at any position near to the optical path space K1 for the exposure light beam EL. In other words, until now, the substrate stage PST has been always subjected to the movement control in an area in which the nozzle member 70 is covered therewith, in view of the prevention of the leakage of the liquid of the liquid immersion area from the substrate stage PST.

However, according to an experiment and the like performed by the present inventor, as shown in Fig. 18, when the substrate stage PST is moved in the +Y direction, the liquid immersion area LR of the liquid LQ intends to expand in the +Y direction. Therefore, the area (areal size), in which the second land surface 76 makes contact with the liquid LQ on the -Y side with respect to the optical path space K1, is relatively small. In this case, it has been clarified that the liquid LQ of the liquid immersion area LR can be retained on condition that only a part of the area of the second land surface 76 faces at least one of the upper surface 94 of the substrate stage PST and the surface of the substrate P, even when all of the area of the second land surface 76, which is disposed on the -Y side with respect to the optical path space K1, does not face at least one of the upper surface 94 of the substrate stage PST and the surface of the substrate P. Therefore, when the substrate stage PST is moved in the +Y direction, the substrate stage PST can be moved until the end 94E on the -Y side of the upper surface 94 of the substrate stage PST is located at the position (on the +Y side in the example shown in Fig. 18) nearer to the optical path space K1 as compared with the end 76E on the -Y side of the second land surface 76.

The following fact will be appreciated. That is, when the control method as described above is used, the liquid LQ can be retained between the substrate stage PST and the nozzle member 70, and the circumferential edge area of the surface of the substrate P can be smoothly subjected to the liquid immersion exposure, even when the upper surface 94 of the substrate stage PST, which is provided on the -Y side of the substrate P, is made small, by setting the movable range of the substrate stage PST as described above. For example, as shown in Fig. 18, when the circumferential edge area on the -Y side of the surface of the substrate P is subjected to the liquid immersion exposure while moving the substrate stage PST in the +Y direction, the liquid LQ can be retained between nozzle member 70 and at least one of the upper surface 94 of the substrate stage PST and the surface of the substrate P. Therefore, it has been also appreciated that the substrate stage PST can be miniaturized.

As described above, it is also possible to miniaturize the substrate stage PST. Therefore, it is possible to suppress the size of the entire exposure apparatus from becoming very large. Further, it is possible to smoothly control the driving operation of the substrate stage PST, because the substrate stage PST can be miniaturized. For example, it is possible to suppress the generation of heat from the actuator for driving the substrate stage PST.

The explanation has been made herein about the positional relationship between the end 94E on the -Y side of the substrate stage PST and the end 76E on the -Y side of the second land surface 76. However, it is possible to set the positional relationship between the end 94E on the +Y side of the substrate stage PST and the end 76E on the +Y side of the second land surface 76 in the same manner as described above. Further, it is also possible to set the positional relationship between the end of the substrate stage PST in the X axis direction and the end of the lower surface of the nozzle member 70 in the X axis direction in the same manner as described above.

The positional relationship between the end 76E of the second land surface 76 and the end 94E of the upper surface 94 of the substrate stage PST capable of retaining the liquid LQ between the substrate stage PST and the nozzle member 70, i.e., the movable range of the substrate stage PST can be previously determined by means of an experiment or simulation in consideration of, for example, the movement condition of the substrate stage PST (for example, the movement velocity and the acceleration) and the surface condition of the substrate P (for example, contact angle with respect to the liquid LQ).

When the end 94E of the upper surface 94 of the substrate stage PST is moved to the position near to the optical path space K1 as compared with the end 76E of the second land surface 76, a predetermined area is formed, which includes, for example, a part of the second land surface 76 of the lower surface of the nozzle member 70 or a part of the porous member 25 arranged in the recovery port 22 and which is not opposite to any one of the upper surface of the substrate stage PST and the surface of the substrate P. In the following description, the predetermined area is appropriately referred to as "overhang area". In this case, there is a possibility that the overhang area makes contact with, for example, the gas flow for adjusting the environment in which the exposure apparatus EX is placed. There is a possibility that the liquid LQ is adhered to the lower surface of the nozzle member 70 (for example, the second land surface 76). Therefore, there is a possibility that a part of the adhered liquid LQ is vaporized due to the contact with the gas flow, and the temperature of the nozzle member 70 varies (temperature decrease) due to the heat of vaporization. When the temperature of the nozzle member 70 varies, there is a possibility that the nozzle member 70 itself is thermally deformed, various members (for example, the final optical element LS1) provided around the nozzle member 70 are thermally deformed, and/or the temperature of the space around the nozzle member 70 is varied. For example, when the final optical element LS1 is thermally deformed and/or the temperature on the optical path for the exposure light beam EL is varied, there is such a possibility that any inconvenience arises to vary the projection state when the pattern image of the mask M is projected onto the substrate P. In such a situation, it is also allowable to provide a temperature adjusting mechanism in order to suppress the temperature change of the nozzle member 70. The temperature adjusting mechanism is exemplified, for example, by a form in which a flow passage distinct from the supply flow passage 14, the gas discharge flow passage 15, and the recovery flow passage 24 is provided in the nozzle member 70, and a fluid (temperature-adjusting fluid) for adjusting the temperature of the nozzle member 70, is allowed to flow through the flow passage. The temperature-adjusting fluid may be supplied to the inside of the recovery flow passage 24. In this case, the temperature-adjusting fluid, which is supplied to the inside of the recovery flow passage 24, is recovered by the liquid recovery unit 21 together with the liquid LQ recovered via the recovery port 22 from the optical path space K1. Alternatively, a jacket member, through which the temperature-adjusting fluid is allowed to flow, may be attached, for example, to the side surface of the nozzle member 70. Further alternatively, a radiation unit, which radiates the heat, may be provided in the vicinity of the nozzle member 70, and the temperature of the nozzle member 70 may be adjusted by the heat radiated from the radiation unit.

As for the nozzle member 70, the fourth embodiment has been explained as exemplified by the nozzle member 70 explained in the first embodiment described above. However, it is possible to use the nozzle members 70 as explained in the second and third embodiments. Alternatively, it is also possible to use any nozzle member 70 other than those described in the first to third embodiments. For example, when the consideration is made about only the achievement of the object to form the overhang area, it is also allowable to arrange recovery ports for the liquid on the +Y side and the -Y side of the optical path space K1. As for the nozzle member 70 having the overhang area, it is enough that the liquid LQ can be retained between the nozzle member 70 and the upper surface of the substrate stage PST. It is allowable to use a member which has only the supply port or a member which has only the recovery port. Alternatively, it is also allowable to use a member which does not have both of the supply port and the recovery port. That is, it is also allowable to separately provide the member (nozzle member) which is capable of retaining the liquid LQ with respect to the upper surface of the substrate stage PST and the member which has the recovery port and the supply port for supplying the liquid. In principle, when the substrate stage PST is moved in the predetermined direction (+Y direction in Fig. 18) in the state in which the liquid immersion area LR is formed on the side of the image plane of the projection optical system PL, the nozzle member is provided, which is arranged so that the lower surface faces the upper surface 94 of the substrate stage PST and which has the lower surface provided so that one end of the liquid immersion area LR in the predetermined direction (end on the -Y side in Fig. 18) is formed at the position near to the optical path space K1. The movable range of the substrate stage PST is set so that the end of the upper surface 94 of the substrate stage PST is movable in the predetermined direction to the position nearer to the optical path space K1 for the exposure light beam EL as compared with the end of the lower surface of the nozzle member 70 in the state in which the liquid LQ is retained between the lower surface of the nozzle member 70 and at least one of the upper surface 94 of the substrate stage PST and the surface of the substrate P held by the substrate stage PST. On this condition, even when the area of the upper surface 94 of the substrate stage PST is small in the predetermined direction, it is possible to maintain the liquid LQ of the liquid immersion area LR.

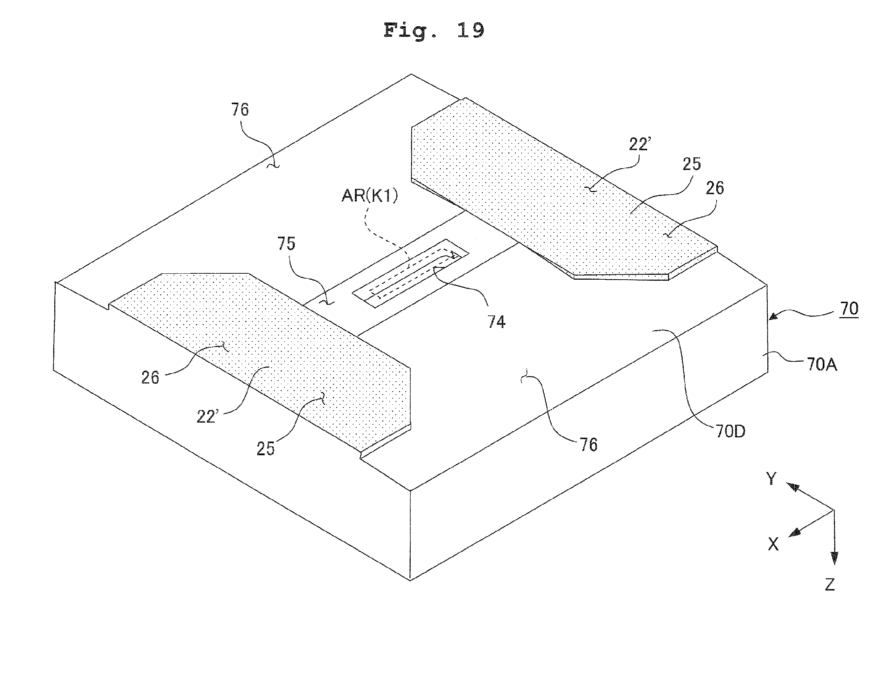

In the fourth embodiment, when at least a part of the recovery port 22 is included in the overhang area, there is such a possibility that the liquid LQ, which flows back from the recovery port 22, outflows onto the substrate stage surface plate 6, for example, by any trouble of the liquid recovery unit 21. Therefore, when it is feared that such a trouble may occur, it is desirable that the position (area) of the recovery port 22 on the lower surface of the nozzle member 70 is set so that at least a part of the recovery port 22 is not included in the overhang area. For example, the recovery ports 22 of the nozzle member 70 of the first embodiment shown in Fig. 3 may be changed to those shown in Fig. 19. As shown in Fig. 19, the length of the recovery port 22' in the Y axis direction is shorter than that of the recovery port 22 of the nozzle member 70 shown in Fig. 3 so that the recovery port 22' of the nozzle member 70 is not included in the overhang area.

In the respective embodiments described above, the opening 74, through which the exposure light beam EL is allowed to pass, is formed at approximately the center of the nozzle member 70, and the projection optical system PL and the nozzle member 70 are arranged so that the optical axis on the side of the image plane of the projection optical system PL is substantially coincident with the center of the nozzle member 70 in the XY plane. However, for example, when a cata-dioptric system is used as the projection optical system PL, there is such a possibility that the irradiation area (projection area AR) of the exposure light beam EL is set at a position deviated from the optical axis on the side of the image plane of the projection optical system PL. In this case, the center of the nozzle member 70 may be deviated from the optical axis AX on the side of the image plane of the projection optical system PL in the XY plane so that the exposure light beam EL passes through the opening 74 of the nozzle member 70. Alternatively, the projection optical system PL and the nozzle member 70 may be arranged so that the optical axis on the side of the image plane of the projection optical system PL is approximately coincident with the center of the nozzle member 70 in the XY plane. Further, the opening 74 may be formed at position deviated from the center of the nozzle member 70 so that the exposure light beam EL passes through the opening 74 of the nozzle member 70.

In the embodiments described above, the first land surface 75 and the second land surface 76 are separated from each other (not flush with each other). However, on condition that the recovery port 22 is provided outside the extending area EA1 or the extending area EA2, the first land surface 75 may be flush with the second land surface 76 (in this arrangement, the first and second surfaces are not distinct from each other). That is, when the expansion of the liquid immersion area LR is permitted to some extent, the liquid immersion area LR can be maintained in a desired state during the scanning exposure provided that the recovery port 22 is provided outside the extending area EA1 or the extending area EA2.

In the embodiments described above, fins, which extend in the scanning direction (Y direction), may be provided on the second land surface 76. By the fins, it is possible to maintain the liquid in the scanning direction more satisfactorily.

In the respective embodiments described above, the optical path space K1 for the exposure light beam EL is filled with the liquid LQ in the state in which the substrate P is arranged at the position capable of being irradiated with the exposure light beam EL. However, the optical path space K1 for the exposure light beam EL may be filled with the liquid LQ, for example, in a state in which an object other than the substrate P and/or the upper surface 94 of the substrate stage PST is arranged at a position at which the exposure light beam EL can be radiated.

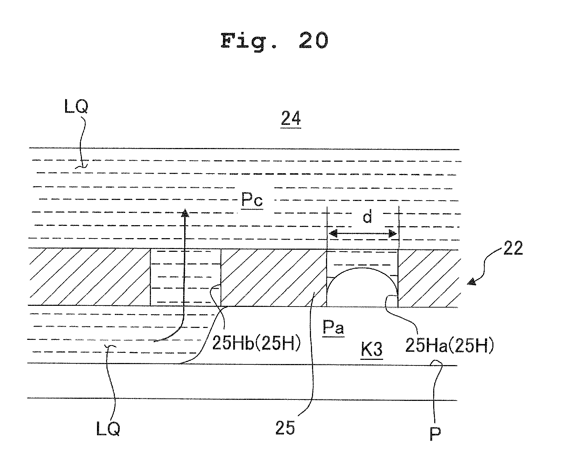

In the respective embodiments described above, the liquid immersion mechanism 1 is provided to recover only the liquid LQ via the recovery ports 22. Therefore, the liquid immersion mechanism 1 can satisfactorily recover the liquid LQ without allowing any gas to flow into the space 24 via the recovery port 22. An explanation will be made below about the principle of the liquid recovery operation by the liquid immersion mechanism 1 with reference to Fig. 20. Fig. 20 shows a sectional view with magnification, illustrating a part of the porous member 25, which schematically explains the liquid recovery operation performed via the porous member 25.

As shown in Fig. 20, the porous member 25 is provided in the recovery port 22. The substrate P is provided below the porous member 25. The gas space and the liquid space are formed between the porous member 25 and the substrate P. More specifically, the gas space is formed between a first hole 25Ha of the porous member 25 and the substrate P, and the liquid space is formed between a second hole 25Hb of the porous member 25 and the substrate P. The recovery flow passage (flow passage space) 24 is formed above the porous member 25.

The liquid immersion mechanism 1 of this embodiment is set so that the following condition is satisfied:

$$(4 \times \gamma \times \cos\theta)/d \geq (Pa - Pc) \qquad \ldots(1)$$

wherein Pa represents the pressure in the space K3 between the substrate P and the first hole 25Ha of the porous member 25 (pressure on the lower surface of the porous member 25H), Pc represents the pressure in the flow passage space 24 above the porous member 25 (pressure on the upper surface of the porous member 25), d represents the pore size (diameter) of the holes 25Ha, 25Hb, θ represents the contact angle between the porous member 25 (inner side surface of the hole 25H) and the liquid LQ, and γ represents the surface tension of the liquid LQ. In the expression (1) described above, the hydrostatic pressure of the liquid LQ above the porous member 25 is not considered in order to simplify the explanation.

In this case, it is necessary that the contact angle θ between the liquid LQ and the porous member 25 (inner side surface of the pore 25H) satisfies the following condition.

$$\theta \leq 90° \qquad\qquad\qquad ...(2)$$

In the case of satisfying the foregoing condition, even when the gas space is formed on the lower side of the first hole 25Ha of the porous member 25 (on the side of the substrate P), then the gas contained in the space K3 on the lower side of the porous member 25 is prevented from any movement (invasion) into the flow passage space 24 on the upper side of the porous member 25 via the hole 25Ha. That is, when the pore size d of the porous member 25, the contact angle (affinity) θ between the porous member 25 and the liquid LQ, the surface tension γ of the liquid LQ, and the pressures Pa, Pc are optimized so that the foregoing condition is satisfied, then the interface between the liquid LQ and the gas can be maintained at the inside of the first hole 25Ha of the porous member 25, and it is possible to suppress the invasion of the gas from the space K3 into the flow passage space 24 via the first hole 25Ha. On the other hand, the liquid space is formed on the lower side of the second hole 25Hb of the porous member 25 (on the side of the substrate P). Therefore, it is possible to recover only the liquid LQ via the second hole 25Hb.

In this embodiment, the pressure Pa of the space K3 on the lower side of the porous member 25, the pore size d, the contact angle θ between the porous member 25 (inner side surface of the hole 25H) and the liquid LQ, and the surface tension γ of the liquid (pure or purified water) LQ are substantially constant. The liquid immersion mechanism 1 adjusts the pressure Pc of the flow passage space 24 on the upper side of the porous member 25 so that the foregoing condition is satisfied by controlling the suction force of the liquid recovery unit 21.

In the expression (1), when the absolute value of (Pa - Pc) is increased, i.e., the absolute value of $((4 \times \gamma \times \cos\theta)/d)$ is increased, the pressure Pc to satisfy the foregoing condition is more easily controlled. Therefore, it is desirable that the pore size d is decreased to be as small as possible, and the contact angle θ between the porous member 25 and the liquid LQ is decreased to be as small as possible. In this embodiment, the porous member 25 has liquid-attracting or lyophilic property with respect to the liquid LQ, and has the sufficiently small contact angle θ.

As described above, in this embodiment, the difference in pressure between the space 24 above the porous member 25 and the space K3 below the porous member 25 (difference in pressure between the upper surface and the lower surface of the porous member 25) is controlled to satisfy the foregoing condition in the state in which the porous member 25 is wet. Accordingly, only the liquid LQ is recovered from the hole 25H of the porous member 25. Thus, it is possible to suppress the occurrence of the vibration which would be otherwise caused such that the liquid LQ and the gas are sucked together.

The liquid immersion mechanism 1, which includes, for example, the nozzle member 70 used in the embodiments described above, is not limited to the structure described above. For example, it is also possible to use those described in European Patent Publication No. 1420298 and International Publication Nos. 2004/055803, 2004/057589, 2004/057590, and 2005/029559. In the embodiments described above, a part of the nozzle member 70 (bottom plate portion 70D) is arranged between the projection optical system PL and the substrate P. However, it is also allowable that a part of the nozzle member 70 is not arranged between the projection optical system PL and the substrate P. That is, the entire lower surface T1 of the final optical element LS1 of the projection optical system PL may be arranged opposite to the substrate P. In the embodiments described above, the supply port 12 is connected to the internal space G2. However, the supply port may be provided on the lower surface of the nozzle member 70.

As described above, pure or purified water is used as the liquid LQ in the embodiment of the present invention. Pure or purified water is advantageous in that pure or purified water is available in a large amount with ease, for example, in the semiconductor production factory, and pure or purified water exerts no harmful influence, for example, on the optical element (lens), the photoresist on the substrate P, and the like. Further, pure or purified water exerts no harmful influence on the environment, and the content of impurity is extremely low. Therefore, it is also expected to obtain the function which washes the surface of the substrate P and the surface of the optical element provided at the end surface of the projection optical system PL. When the purity of pure or purified water supplied from the factory or the like is low, it is also allowable that the exposure apparatus has an ultrapure water-producing unit.

It is approved that the refractive index n of pure or purified water (water) with respect to the exposure light beam EL having a wavelength of about 193 nm is approximately 1.44. When the ArF excimer laser beam (wavelength: 193 nm) is used as the light source of the exposure light beam EL, then the wavelength is shortened on the substrate P by 1/n, i.e., to about 134 nm, and a high resolution is obtained. Further, the depth of focus is magnified about n times, i.e., about 1.44 times as compared with the value obtained in the air. Therefore, when it is enough to secure an approximately equivalent depth of focus as compared with the case of the use in the air, it is possible to further increase the numerical aperture of the projection optical system PL. Also in this viewpoint, the resolution is improved.

In the embodiment of the present invention, the optical element LS1 is attached to the end portion of the projection optical system PL. The lens can be used to adjust the optical characteristics of the projection optical system PL, including, for example, the aberration (for example, spherical aberration and comatic aberration). The optical element, which is attached to the end portion of the projection optical system PL, may be an optical plate which is usable to adjust the optical characteristics of the projection optical system PL. Alternatively, the optical element may be a plane parallel plate through which the exposure light beam EL is transmissive.

When the pressure, which is generated by the flow of the liquid LQ, is large between the substrate P and the optical element disposed at the end portion of the projection optical system PL, it is also allowable that the optical element is tightly fixed so that the optical element is not moved by the pressure, without allowing the optical element to be exchangeable.

In the embodiment of the present invention, the space between the projection optical system PL and the surface of the substrate P is filled with the liquid LQ. However, for example, it is also allowable that the space is filled with the liquid LQ in a state in which a cover glass composed of a plane parallel plate is attached to the surface of the substrate P.

In the projection optical system according to the embodiment described above, the optical path space, which is disposed on the side of the image plane of the optical element arranged at the end portion, is filled with the liquid. However, it is also possible to adopt such a projection optical system that the optical path space, which is disposed on the mask side of the optical element arranged at the end portion, is also filled with the liquid, as disclosed in pamphlet of International Publication No. 2004/019128.

The liquid LQ is water in the embodiment of the present invention. However, the liquid LQ may be any liquid other than water. For example, when the light source of the exposure light beam EL is the $F_2$ laser, the $F_2$ laser beam is not transmitted through water. Therefore, in this case, liquids preferably usable as the liquid LQ may include, for example, fluorine-based fluids such as fluorine-based oil and perfluoropolyether (PFPE) through which the $F_2$ laser beam is transmissive. In this case, the portion, which makes contact with the liquid LQ, is subjected to a liquid-attracting or lyophilic treatment by forming a thin film with a substance having a molecular structure of small polarity including fluorine. Alternatively, other than the above, it is also possible to use, as the liquid LQ, liquids (for example, cedar oil) which have the transmittance with respect to the exposure light beam EL, which have the refractive index as high as possible, and which are stable against the photoresist coated on the surface of the substrate P and the projection optical system PL.

Liquids having refractive indexes of about 1.6 to 1.8 may be used as the liquid LQ. Further, the optical element LS1 may be formed of a material having a refractive index (for example, not less than 1.6) higher than those of silica glass and calcium fluoride. It is also possible to use, as the liquid LQ, various liquids including, for example, supercritical liquids.

The substrate P, which is usable in the respective embodiments described above, is not limited to the semiconductor wafer for producing the semiconductor device. Those applicable include, for example, the glass substrate for the display device, the ceramic wafer for the thin film magnetic head, and the master plate (synthetic silica glass, silicon wafer) for the mask or the reticle to be used for the exposure apparatus.

As for the exposure apparatus EX, the present invention is also applicable to the scanning type exposure apparatus (scanning stepper) based on the step-and-scan system for performing the scanning exposure with the pattern of the mask M by synchronously moving the mask M and the substrate P as well as the projection exposure apparatus (stepper) based on the step-and-repeat system for performing the full field exposure with the pattern of the mask M in a state in which the mask M and the substrate P are allowed to stand still, while successively step-moving the substrate P.

As for the exposure apparatus EX, the present invention is also applicable to the exposure apparatus of such a system that the substrate P is subjected to the full field exposure by using a projection optical system (for example, the dioptric type projection optical system having a reduction magnification of 1/8 and including no catoptric element) with a reduction image of a first pattern in a state in which the first pattern and the substrate P are allowed to substantially stand still. In this case, the present invention is also applicable to the full field exposure apparatus based on the stitch system in which the substrate P is thereafter subjected to the full field exposure with a reduction image of a second pattern while being partially overlaid with the first pattern in a state in which the second pattern and the substrate P are allowed to substantially stand still by using the projection optical system. As for the exposure apparatus based on the stitch system, the present invention is also applicable to the exposure apparatus based on the step-and-stitch system in which at least two patterns are partially overlaid and transferred on the substrate P, and the substrate P is successively moved. The embodiments described above have been explained as exemplified by the exposure apparatus provided with the projection optical system PL by way of example. However, the present invention is applicable to the exposure apparatus and the exposure method in which the projection optical system PL is not used. Even when the projection optical system PL is not used as described above, then the exposure light beam is radiated onto the substrate via an optical member such as a lens, and the liquid immersion area is formed in a predetermined space between such an optical member and the substrate. The present invention is also applicable to the exposure apparatus in which a line-and-space pattern is formed on the substrate P by forming interference fringes on the substrate P, as disclosed in pamphlet of International Publication No. 2001/035168.

The present invention is also applicable to an exposure apparatus of the twin-stage type provided with a plurality of substrate stages as disclosed, for example, in Japanese Patent Application Laid-open Nos. 10-163099 and 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), and United States Patent No. 6,208,407. The disclosures of the United States Patent documents are incorporated herein by reference within a range of permission of the domestic laws and ordinances of the state designated or selected in this international application.

The present invention is also applicable to the exposure apparatus including the substrate stage which holds the substrate P and the measuring stage which carries various photoelectric sensors and/or reference member in which reference mark is formed, as disclosed, for example, in Japanese Patent Application Laid-open Nos. 11-135400 and 2000-164504. In this case, the liquid immersion area LR can be also formed on the measuring stage.

In the embodiments described above, the light-transmissive type mask is used, in which the predetermined light-shielding pattern (or a phase pattern or a light-reducing or dimming pattern) is formed on the light-transmissive substrate. However, in place of such a mask, as disclosed, for example, in United States Patent No. 6,778,257, it is also allowable to use an electronic mask for forming a transmissive pattern, a reflective pattern, or a light-emitting pattern on the basis of the electronic data of the pattern to be transferred.

The present invention is also applicable to the exposure apparatus (lithography system) in which a line-and-space pattern is transferred onto the substrate P by forming interference fringes on the substrate P as disclosed in International Publication No. 2001/035168.

As described above, the exposure apparatus EX according to the embodiment of the present invention is produced by assembling the various subsystems including the respective constitutive elements as defined in claims so that the predetermined mechanical accuracy, the electric accuracy, and the optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include, for example, the mechanical connection, the wiring connection of the electric circuits, and the piping connection of the air pressure circuits in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which, for example, the temperature and the cleanness are managed.

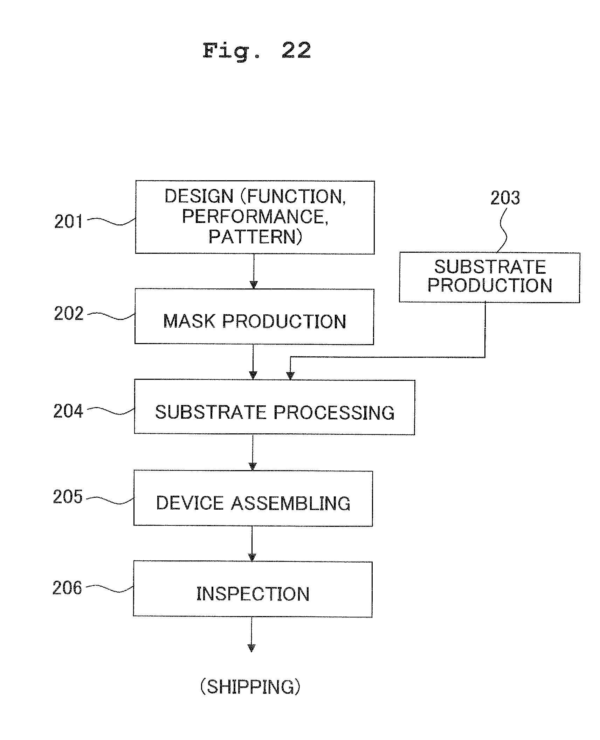

As shown in Fig. 22, the microdevice such as the semiconductor device is produced by performing, for example, a step 201 of designing the function and the performance of the microdevice, a step 202 of manufacturing a mask (reticle) based on the designing step, a step 203 of producing a substrate as a base material for the device, a substrate-processing (exposure process) step 204 of transferring a pattern of the mask to the substrate by using the exposure apparatus EX of the embodiment described above and developing the exposed substrate, a step 205 of assembling the device (including a dicing step, a bonding step, and a packaging step), and an inspection step 206.

INDUSTRIAL APPLICABILITY

As for the type of the exposure apparatus EX, the present invention is not limited to the exposure apparatus for the semiconductor device production, which transfers the semiconductor device pattern to the substrate P. The present invention is also widely applicable, for example, to the exposure apparatus for producing the liquid crystal display device or for producing the display as well as the exposure apparatus for producing, for example, the thin film magnetic head, the image pickup device (CCD), the reticle, or the mask.

**Claims**

1. An exposure apparatus which exposes a substrate by radiating an exposure light beam onto the substrate while moving the substrate in a predetermined direction, the exposure apparatus comprising:

   a first surface which is provided opposite to a surface of an object arranged at a position capable of being irradiated with the exposure light beam and which is provided to surround an optical path space for the exposure light beam;
   a second surface which is provided opposite to the surface of the object and which is provided outside the first surface with respect to the optical path space for the exposure light beam in the predetermined direction; and

a recovery port which recovers a liquid for filling the optical path space for the exposure light beam therewith, wherein:

the first surface is provided substantially in parallel to the surface of the object;
the second surface is provided at a position separated farther from the surface of the object than the first surface; and
the recovery port is provided at a position different from those of the first surface and the second surface.

2.  The exposure apparatus according to claim 1, wherein the object includes the substrate.

3.  An exposure apparatus which exposes a substrate by radiating an exposure light beam onto the substrate while moving the substrate in a predetermined direction, the exposure apparatus comprising:

a first surface which is provided opposite to a surface of an object arranged at a position capable of being irradiated with the exposure light beam and which is provided to surround an optical path space for the exposure light beam;
a second surface which is provided opposite to the surface of the object and which is provided outside the first surface with respect to the optical path space for the exposure light beam in the predetermined direction; and
a recovery port which recovers a liquid for filling the optical path space for the exposure light beam therewith, wherein:

the first surface is provided substantially in parallel to the surface of the object;
the second surface is provided at a position separated farther from the surface of the object than the first surface; and
the recovery port is provided on the second surface, and a size of the recovery port is smaller than a size of the exposure light beam as viewed in a cross section.

4.  The exposure apparatus according to claim 1 or 3, wherein the first surface and the second surface are provided in a predetermined positional relationship to prevent the liquid, which exists between the surface of the object and the second surface, from being separated from the second surface.

5.  An exposure apparatus which exposes a substrate by radiating an exposure light beam onto the substrate while moving the substrate in a predetermined direction, the exposure apparatus comprising:

a first surface which is provided opposite to a surface of an object arranged at a position capable of being irradiated with the exposure light beam and which is provided to surround an optical path space for the exposure light beam;
a second surface which is provided opposite to the surface of the object and which is provided outside the first surface with respect to the optical path space for the exposure light beam in the predetermined direction; and
a recovery port which recovers a liquid for filling the optical path space for the exposure light beam therewith, wherein:

the first surface is provided substantially in parallel to the surface of the object;
the second surface is provided at a position separated farther from the surface of the object than the first surface; and
the first surface and the second surface are provided in a predetermined positional relationship to prevent the liquid, which exists between the surface of the object and the second surface, from being separated from the second surface.

6.  The exposure apparatus according to any one of claims 1, 3, and 5, wherein the second surface is provided substantially in parallel to the surface of the object, and a difference in height is provided between the first surface and the second surface.

7.  The exposure apparatus according to claim 6, wherein the difference in height is not more than 1 mm.

8.  An exposure apparatus which exposes a substrate by radiating an exposure light beam onto the substrate while moving the substrate in a predetermined direction, the exposure apparatus comprising:

a first surface which is provided opposite to a surface of an object arranged at a position capable of being irradiated with the exposure light beam and which is provided to surround an optical path space for the exposure light beam;
a second surface which is provided opposite to the surface of the object and which is provided outside the first surface with respect to the optical path space for the exposure light beam in the predetermined direction; and
a recovery port which recovers a liquid for filling the optical path space for the exposure light beam therewith, wherein:

the first surface is provided substantially in parallel to the surface of the object;
the second surface is provided substantially in parallel to the surface of the object at a position separated farther from the surface of the object than the first surface; and
a difference in height provided between the first surface and the second surface is not more than 1 mm.

9. The exposure apparatus according to any one of claims 1, 3, and 5, wherein the second surface is an inclined surface in which a distance with respect to the surface of the object is increased at positions separated farther from the optical path space for the exposure light beam in the predetermined direction.

10. The exposure apparatus according to claim 9, wherein the second surface is provided continuously to the first surface.

11. The exposure apparatus according to claim 9, wherein an angle, which is formed by the first surface and the second surface, is not more than 10 degrees.

12. An exposure apparatus which exposes a substrate by radiating an exposure light beam onto the substrate while moving the substrate in a predetermined direction, the exposure apparatus comprising:

a first surface which is provided opposite to a surface of an object arranged at a position capable of being irradiated with the exposure light beam and which is provided to surround an optical path space for the exposure light beam;
a second surface which is provided opposite to the surface of the object and which is provided outside the first surface with respect to the optical path space for the exposure light beam in the predetermined direction; and
a recovery port which recovers a liquid for filling the optical path space for the exposure light beam therewith, wherein:

the first surface is provided substantially in parallel to the surface of the object;
the second surface is provided at a position separated farther from the surface of the object than the first surface, the second surface being an inclined surface in which a distance with respect to the surface of the object is increased at positions separated farther from the optical path space for the exposure light beam in the predetermined direction; and
an angle, which is formed by the first surface and the second surface, is not more than 10 degrees.

13. The exposure apparatus according to any one of claims 1, 3, 5, 8, and 12, wherein the first surface and the second surface have liquid-attracting property with respect to the liquid respectively.

14. The exposure apparatus according to any one of claims 1, 3, 5, 8, and 12, wherein a contact angle between the first surface and the liquid is substantially equal to a contact angle between the second surface and the liquid.

15. The exposure apparatus according to any one of claims 1, 3, 5, 8, and 12, further comprising:

a third surface which is provided opposite to the surface of the object and which is provided outside the first surface with respect to the optical path space for the exposure light beam in a direction intersecting with the predetermined direction, wherein:

the third surface is provided at a position separated farther from the surface of the object than the first surface; and
the first surface and the third surface are provided in a predetermined positional relationship to prevent the liquid, which exists between the surface of the object and the third surface, from being separated from the third surface.

16. The exposure apparatus according to claim 15, wherein the recovery port is provided between the third surface and the optical path space for the exposure light beam.

17. The exposure apparatus according to claim 15, wherein the third surface is an inclined surface in which a distance with respect to the surface of the object is increased at positions separated farther from the optical path space for the exposure light beam in the direction intersecting with the predetermined direction.

18. The exposure apparatus according to claim 15, wherein the third surface has liquid-attracting property with respect to the liquid.

19. The exposure apparatus according to claim 15, wherein a contact angle between the first surface and the liquid is subsequently equal to a contact angle between the third surface and the liquid.

20. The exposure apparatus according to any one of claims 1, 3, 5, 8, and 12, wherein the first surface has a rectangular outer shape in which the direction intersecting with the predetermined direction is a longitudinal direction.

21. The exposure apparatus according to any one of claims 1, 3, 5, 8, and 12, further comprising:

an optical member through which the exposure light beam passes;
a predetermined member which has an opening through which the exposure light beam passes and which is provided between the optical member and the object; and
a supply port which supplies the liquid to a space between the optical member and the predetermined member, wherein:

the first surface is formed on the predetermined member to surround the opening; and
the liquid is supplied from the supply port to fill the optical path space for the exposure light beam between the optical member and the object with the liquid.

22. The exposure apparatus according to claim 21, wherein a width of the first surface in the predetermined direction is smaller than a width of the opening in the predetermined direction.

23. The exposure apparatus according to claim 21, wherein a first recess is formed in the vicinity of the supply port on a surface, of the predetermined member, facing the optical member.

24. The exposure apparatus according to claim 21, further comprising a gas discharge port which is provided in the vicinity of a predetermined space between the optical member and the predetermined member, and which communicates the predetermined space and an external space.

25. The exposure apparatus according to claim 24, wherein a second recess is formed in the vicinity of the gas discharge port on a surface, of the predetermined member, facing the optical member.

26. The exposure apparatus according to any one of claims 1, 3, 5, 8, and 12, further comprising:

an optical member through which the exposure light beam passes;
a predetermined member which has an opening through which the exposure light beam passes and which is provided between the optical member and the object;
a gas discharge port which is provided in the vicinity of a predetermined space between the optical member and the predetermined member, and which communicates the predetermined space and an external space; and
a second recess which is formed in the vicinity of the gas discharge port on a surface, of the predetermined member, facing the optical member.

27. The exposure apparatus according to any one of claims 1, 3, 5, 8, and 12, further comprising:

a substrate stage which is movable while holding the substrate and which has an upper surface capable of retaining the liquid between the first surface and the second surface, wherein:

a movable range of the substrate stage is set to make an end of the upper surface of the substrate stage to be movable in the predetermined direction to a position closer to the optical path space for the exposure light beam than an end of the second surface in a state in which a liquid immersion area is formed on at least one of the upper surface of the substrate stage and a surface of the substrate held by the substrate stage.

28. An exposure apparatus which exposes a substrate by radiating an exposure light beam onto the substrate while moving the substrate in a predetermined direction, the exposure apparatus comprising:

a substrate stage which is movable while holding the substrate; and
a nozzle member which has a lower surface arranged to surround an optical path space for the exposure light beam and to face an upper surface of the substrate stage and which is capable of retaining a liquid between the lower surface and the upper surface of the substrate stage, wherein:

a movable range of the substrate stage is controlled to move an end of the upper surface of the substrate stage in the predetermined direction to a position closer to the optical path space for the exposure light beam than an end of the lower surface of the nozzle member in a state in which the liquid is retained between the lower surface of the nozzle member and at least one of the upper surface of the substrate stage and a surface of the substrate held by the substrate stage.

29. The exposure apparatus according to claim 28, wherein the nozzle member has at least one of a supply port which supplies the liquid for filling the optical path space for the exposure light beam therewith and a recovery port which recovers the liquid in the optical path space.

30. An exposure apparatus which exposes a substrate by radiating an exposure light beam onto the substrate through a liquid while moving the substrate in a predetermined direction, the exposure apparatus comprising:

a liquid immersion mechanism which forms a liquid immersion area of the liquid on the substrate; and
a recovery port which is provided in the liquid immersion mechanism to recover the liquid on the substrate, wherein:

the recovery port is provided outside an extending area which extends in the predetermined direction with respect to an optical path space for the exposure light beam which passes through the liquid.

31. The exposure apparatus according to claim 30, wherein the recovery port is provided on each of both sides of the extending area in a direction perpendicular to the predetermined direction.

32. The exposure apparatus according to claim 31, wherein:

the liquid immersion mechanism has a lower surface which is provided opposite to the substrate and which is provided to surround the optical path space;
the lower surface includes the extending area; and
the recovery port is provided on a portion of the lower surface.

33. The exposure apparatus according to claim 31, wherein the extending area has a first surface which is provided substantially in parallel to a surface of the substrate, and a second surface which is separated farther from the surface of the substrate than the first surface.

34. The exposure apparatus according to claim 33, wherein the second surface is inclined with respect to the first surface.

35. The exposure apparatus according to claim 31, wherein the extending area is provided on each of both sides of the optical path space in the predetermined direction.

36. A method for producing a device, comprising:

exposing a substrate by using the exposure apparatus as defined in any one of claims 1, 3, 5, 8, 12, 28, and 30;
developing the exposed substrate; and
processing the developed substrate.

37. An exposure method for exposing a substrate, the exposure method comprising:

providing a liquid on the substrate;
exposing the substrate by radiating an exposure light beam through the liquid onto the substrate while moving the substrate in a predetermined direction; and
recovering the liquid outside an extending area which extends in the predetermined direction with respect to an optical path space for the exposure light beam which passes through the liquid.

**38.** The exposure method according to claim 37, wherein the liquid is recovered outside the extending area while moving the substrate in the predetermined direction.

**39.** The exposure method according to claim 37, further comprising supplying the liquid while moving the substrate in the predetermined direction.

**40.** A method for producing a device, comprising:

exposing a substrate by using the exposure method as defined in claim 37;
developing the exposed substrate; and
processing the developed substrate.

# Fig. 1

EP 1 865 542 A1

Fig. 2

# Fig. 3

(a)

(b)

Fig. 4

Fig. 5

Fig. 6

(A)

K1       70

LG

LQ

P

LR

(B)

K1       70

LG

LQ

P

LR

SCANNING
MOVEMENT

Z

Y

Fig. 7

Fig. 8

(A)

(B)

SCANNING
MOVEMENT

# Fig. 9

EP 1 865 542 A1

Fig. 10

Fig. 11

EP 1 865 542 A1

Fig. 12

EP 1 865 542 A1

## Fig. 13

(A)

(B)

SCANNING MOVEMENT

Fig. 14

EP 1 865 542 A1

## Fig. 15

Fig. 16

Fig. 17

EP 1 865 542 A1

Fig. 18

## Fig. 19

# Fig. 20

Fig. 21

LS1

700

702

P

LQ

Z

Y

# Fig. 22

```
201 ──╮  ┌─────────────────────────┐           203 ──╮
       │ │  DESIGN (FUNCTION,       │                 │
       └─│  PERFORMANCE,            │                 │
         │  PATTERN)                │                 │
         └─────────────────────────┘        ┌──────────────────┐
                      │                      │   SUBSTRATE      │
                      ▼                      │   PRODUCTION     │
202 ──╮  ┌─────────────────────────┐        └──────────────────┘
       └─│  MASK PRODUCTION         │                 │
         └─────────────────────────┘                 │
                      │                               │
                      ▼               ◄───────────────┘
204 ──╮  ┌─────────────────────────┐
       └─│  SUBSTRATE PROCESSING    │
         └─────────────────────────┘
                      │
                      ▼
205 ──╮  ┌─────────────────────────┐
       └─│  DEVICE ASSEMBLING       │
         └─────────────────────────┘
                      │
                      ▼
206 ──╮  ┌─────────────────────────┐
       └─│  INSPECTION              │
         └─────────────────────────┘
                      │
                      ▼
                 (SHIPPING)
```

## INTERNATIONAL SEARCH REPORT

| International application No. |
| --- |
| PCT/JP2006/306711 |

A.  CLASSIFICATION OF SUBJECT MATTER
*H01L21/027*(2006.01), *G03F7/20*(2006.01)

According to International Patent Classification (IPC) or to both national classification and IPC

B.  FIELDS SEARCHED

Minimum documentation searched (classification system followed by classification symbols)
H01L21/027, G03F7/20

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho   1971-2006   Toroku Jitsuyo Shinan Koho   1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>Y | JP 2005-019864 A  (Canon Inc.),<br>20 January, 2005 (20.01.05),<br>Par. Nos. [0060] to [0159]; Figs. 3 to 6<br>& US 2004/0263809 A1 | 1-8<br>9-40 |
| X | JP 2005-012228 A  (ASML Holding N.V.),<br>13 January, 2005 (13.01.05),<br>Par. Nos. [0012] to [0045]; Figs. 1 to 4<br>& EP 1489462 A2 | 1-8 |
| X | JP 2004-349645 A  (Sony Corp.),<br>09 December, 2004 (09.12.04),<br>Par. Nos. [0015] to [0060]; Figs. 1, 2<br>(Family: none) | 1-8 |

| ☒ | Further documents are listed in the continuation of Box C. | ☐ | See patent family annex. |

| * | Special categories of cited documents: |
| --- | --- |
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>23 May, 2006 (23.05.06) | Date of mailing of the international search report<br>06 June, 2006 (06.06.06) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2006/306711

C (Continuation).   DOCUMENTS CONSIDERED TO BE RELEVANT

| Category* | Citation of document, with indication, where appropriate, of the relevant passages | Relevant to claim No. |
|---|---|---|
| X | JP 2004-289126 A  (ASML Holding N.V.),<br>14 October, 2004 (14.10.04),<br>Par. Nos. [0034] to [0097]; Figs. 1 to 10<br>& EP 1420298 A2 | 1-8 |
| X | WO 2004/055803 A1  (Koninklijke Philips<br>Electronics N.V.),<br>01 July, 2004 (01.07.04),<br>Page 3, line 26 to page 12, line 26; Figs. 1<br>to 4<br>& JP 2005-510146 A | 1-8 |
| Y | JP 2005-045232 A  (Nikon Corp.),<br>17 February, 2005 (17.02.05),<br>Par. Nos. [0025] to [0093]; Figs. 1 to 6<br>& WO 2005/006418 A1 | 9-40 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9949504 A
- EP 1420298 A
- WO 2004055803 A
- WO 2004057589 A
- WO 2004057590 A
- WO 2005029559 A
- WO 2004019128 A
- JP 10163099 A
- JP 10214783 A
- US 6341007 B
- US 6400441 B
- US 6549269 B
- US 6590634 B
- JP 2000505958 A
- US 5969441 A
- US 6208407 B
- JP 11135400 A
- JP 2000164504 A
- US 6778257 B
- WO 2001035168 A